# EUROPÄISCHE PATENTSCHRIFT

(11) **EP 3 888 430 B1**
(45) Veröffentlichungstag und Bekanntmachung des Hinweises auf die Patenterteilung: **22.03.2023**
(21) Anmeldenummer: 19821065.0
(22) Anmeldetag: 11.12.2019
(51) Int. Cl.: H05K 7/14

(54) **BASISMODUL UND FUNKTIONSMODUL FÜR EIN SCHALTSCHRANKSYSTEM UND SCHALTSCHRANKSYSTEM**
BASE MODULE AND FUNCTIONAL MODULE FOR AN ELECTRICAL ENCLOSURE SYSTEM, AND ELECTRICAL ENCLOSURE SYSTEM
MODULE DE BASE ET MODULE FONCTIONNEL POUR UN SYSTÈME D'ARMOIRE ÉLECTRIQUE ET SYSTÈME D'ARMOIRE ÉLECTRIQUE

(30) Priorität: 28.12.2018 DE 102018133657
(43) Veröffentlichungstag der Anmeldung: 06.10.2021
(73) Patentinhaber: Beckhoff Automation GmbH, 33415 Verl (DE)
(72) Erfinder: BECKHOFF, Hans, 33415 Verl (DE); BÜTTNER, Holger, 12205 Berlin (DE); SIEGENBRINK, Daniel, 33617 Bielefeld (DE)
(74) Vertreter: Patentanwaltskanzlei WILHELM & BECK
(86) Internationale Anmeldenummer: PCT/EP2019/084699
(87) Internationale Veröffentlichungsnummer: WO 2020/136010

(56) Entgegenhaltungen:
- DE-A1- 19 902 745
- US-A- 4 152 750
- US-A1- 2006 259 670
- Dokumentation "EP9128 - EtherCAT-Sternverteiler in Schutzart IP67 - Version 2.2.0" (BECKHOFF GmbH)

## Beschreibung

Die Patentanmeldung beansprucht die Priorität der deutschen Patentanmeldung 10 2018 133 657.8.

Die vorliegende Erfindung betrifft ein Basismodul und ein Funktionsmodul für ein Schaltschranksystem und ein Schaltschranksystem.

Aus der Offenlegungsschrift DE 100 06 879 A1 ist eine modulare Steuerungsanlage mit einem Basismodul und mit dem Basismodul verbundenen Funktionsmodulen bekannt. Ein Nachteil der modularen Steuerungsanlage besteht darin, dass bei einem Defekt eines Funktionsmoduls eine Kommunikation auf einem Feldbus der Steuerungsanlage unterbrochen werden kann, sodass Feldbusteilnehmer, die von einer Steuerung die Steuerungsanlage umfassenden Automatisierungssystems aus gesehen hinter dem betroffenen Funktionsmodul angeordnet sind, von der Steuerung nicht angesprochen werden können. Auch bei einem Austausch eines Funktionsmoduls kann die Kommunikation auf dem Feldbus unterbrochen werden. Somit kann es sein, dass kein Austausch von Komponenten während des laufenden Betriebs des Automatisierungssystems vorgenommen werden kann. Stattdessen muss das Automatisierungssystem und die Kommunikation auf dem Feldbus nach dem Austausch eines Funktionsmoduls neu gestartet werden, was bei einem Einsatz des Automatisierungssystems beispielsweise in einer Produktionsmaschine einen unerwünschten Produktionsausfall bedeuten würde, da die Produktionsmaschine nicht kontinuierlich betrieben werden könnte.

Aus der Druckschrift US 4152 750 A ist ein Schnittstellen-Rack bekannt, das eine Feldverdrahtung direkt an Schnittstellenschaltkreisklemmen ermöglicht, wodurch Funktionsmodule entfernt oder ersetzt werden können, ohne die Verdrahtung zu trennen und neu verbinden zu müssen.

Aus der DE 199 02 745 A1 ist eine modulare Konstruktion mit einem vereinfachten Aufbau und kleinen Abmessungen bekannt, bei der Stromschienen zur Potentialzuführung zu den Anschlussebenen auf beide Seiten eines Basis- Klemmenträgers verteilt sind und die Stromschienen jedes einzelnen Potentials nur jeweils auf einer der Seiten des Basis-Klemmenträgers zu den zugehörigen Anschlüssen geführt sind.

Aus der US 2006/259670 A1 ist ein Buskoppler bekannt, der es ermöglicht, Verbraucherabzweige an Rückwandbusse anzukoppeln, ohne dass die Gefahr besteht, dass die Abzweigungen beschädigt werden. Hierzu ist ein Rückwandbusmodul mit einem Koppelelement vorgesehen, mit dem eine Punkt-zu-Punkt-Kommunikationsverbindung zu einem Automatisierungsgerät besteht.

Aus der technischen Dokumentation "EP9128: EtherCAT-Sternverteiler in Schutzart IP67" ist ein Modul bekannt, dass es ermöglicht, verschiedene Netzwerktopologien in einem Kommunikationsnetzwerk zu realisieren.

Eine Aufgabe der vorliegenden Erfindung besteht darin, ein verbessertes Basismodul für ein Schaltschranksystem, ein verbessertes Funktionsmodul für ein Schaltschranksystem und ein Schaltschranksystem mit einem Basismodul und einem Funktionsmodul bereitzustellen. Diese Aufgabe wird durch ein Basismodul für ein Schaltschranksystem, durch ein Funktionsmodul für ein Schaltschranksystem und durch ein Schaltschranksystem mit einem Basismodul und einem Funktionsmodul mit den Merkmalen der unabhängigen Ansprüche gelöst. In abhängigen Ansprüchen sind vorteilhafte Weiterbildungen angegeben.

Ein erfindungsgemäßes Basismodul für ein Schaltschranksystem weist eine Mehrzahl von Anschalteinheiten und Anschlusselementen für eine Mehrzahl von Funktionsmodulen auf. Die Anschlusselemente sind dazu ausgebildet, in Modulanschlusselemente von Funktionsmodulen einzugreifen. Jedes Anschlusselement weist zumindest einen Datenanschluss auf. Jede Anschalteinheit ist jeweils zumindest mit einem Datenanschluss eines Anschlusselements verbunden. Die Anschalteinheiten sind durch einen Datenbus miteinander verbunden. Das Basismodul weist einen ersten Feldbusanschluss auf. Der Datenbus ist zum Anbinden der Anschalteinheiten an einen Feldbus mit dem ersten Feldbusanschluss verbunden.

Das Basismodul kann über dessen Anschlusselemente mit Funktionsmodulen verbunden werden, um das Schaltschranksystem zu bilden. Ein Schaltschranksystem umfasst elektrische und elektronische Komponenten eines Automatisierungssystems. Ein Schaltschranksystem bildet zusammen mit angeschlossenen Feldgeräten ein Automatisierungssystem. Ein Schaltschranksystem fungiert als Verteilersystem. Beispielsweise können elektrische Spannungen vom Schaltschranksystem verteilt und Feldgeräten bereitgestellt werden.

Die Anschalteinheiten, die auch als Slaves bezeichnet werden können, sind durch den Datenbus miteinander verbunden und bilden ein Kommunikationsnetzwerk im Schaltschranksystem. Die Anschalteinheiten können also Daten miteinander austauschen. Über die mit den Anschlusselementen verbundenen Anschalteinheiten kann auch eine Kommunikation bzw. ein Datenaustausch zwischen dem Basismodul und Funktionsmodulen erfolgen. Alle Anschalteinheiten sind in dem Basismodul angeordnet. Dadurch bietet das Basismodul den Vorteil, dass im Fall eines Defekts oder eines Austauschs eines Funktionsmoduls alle noch intakten Funktionsmodule über den Datenbus angesprochen werden können. Aus diesem Grund kann ein Funktionsmodul im laufenden Betrieb eines Automatisierungssystems ausgetauscht werden. Darüber hinaus muss ein Automatisierungssystem nicht initialisiert werden, wenn ein konfiguriertes Funktionsmodul, das ein Funktionsmodul ersetzt, an das Basismodul angeschlossen wird. Wird das Automatisierungssystem beispielsweise in einer Produktionsmaschine eingesetzt, kann dies einen unerwünschten Produktionsausfall verhindern.

In einer Ausführungsform bildet ein erster Datenanschluss eines ersten Anschlusselements den ersten Feldbusanschluss. Der erste Datenanschluss ist dazu ausgebildet, in einen ersten Moduldatenanschluss eines ersten Modulanschlusselements eines Funktionsmoduls einzugreifen. Vorteilhafterweise kann ein als Einspeisemodul ausgebildetes Funktionsmodul auf diese Weise Daten über den ersten Datenanschluss übermitteln und empfangen.

In einer Ausführungsform bildet ein erster Datenanschluss eines zweiten Anschlusselements einen zweiten Feldbusanschluss, mit welchem der Datenbus verbunden ist. Der erste Datenanschluss des zweiten Anschlusselements ist dazu ausgebildet, in einen ersten Moduldatenanschluss eines zweiten Modulanschlusselements eines Funktionsmoduls einzugreifen. Vorteilhafterweise, können die Anschalteinheiten über den zweiten Feldbusanschluss in redundanter Art und Weise angesprochen werden. Fällt beispielsweise eine Anschalteinheit aus, so können alle Anschalteinheiten, die zwischen dem ersten Feldbusanschluss und der defekten Anschalteinheit angeordnet sind, vom ersten Feldbusanschluss aus angesprochen werden. Alle Anschalteinheiten, die zwischen der defekten Anschalteinheit und dem zweiten Feldbusanschluss angeordnet sind, können vom zweiten Feldbusanschluss aus angesprochen werden. Alternativ ermöglicht es der zweite Feldbusanschluss, dass das Basismodul an ein weiteres Basismodul angeschlossen werden kann. Dabei wird der zweite Feldbusanschluss an einen Feldbusanschluss des weiteren Basismoduls angeschlossen.

In einer Ausführungsform bildet ein erster Spannungsanschluss eines der Anschlusselemente einen ersten Versorgungsanschluss zum Einspeisen einer ersten Versorgungsspannung in das Basismodul. Zumindest eines der übrigen Anschlusselemente weist einen weiteren ersten Spannungsanschluss zum Weiterleiten der ersten Versorgungsspannung an ein Funktionsmodul auf. Der erste Versorgungsanschluss ist mit dem weiteren ersten Spannungsanschluss verbunden. Vorteilhafterweise kann somit die erste Versorgungsspannung Funktionsmodulen bereitgestellt werden. Die erste Versorgungsspannung kann beispielsweise dazu verwendet werden, an Funktionsmodule angeschlossene Feldgeräte zu betreiben.

In einer Ausführungsform weist das Basismodul eine an den Datenbus angebundene Sicherungseinrichtung auf, welche zumindest mit einer Sicherungsschaltung verbunden ist. Die Sicherungsschaltung ist mit dem ersten Versorgungsanschluss verbunden. Die Sicherungsschaltung ist zum abgesicherten Weiterleiten der ersten Versorgungsspannung an ein Funktionsmodul mit dem weiteren ersten Spannungsanschluss verbunden. Vorteilhafterweise können es die Sicherungseinrichtung und die Sicherungsschaltung ermöglichen, dass die erste Versorgungsspannung nicht an ein Funktionsmodul weitergeleitet wird, wenn die erste Versorgungsspannung außerhalb eines zulässigen Bereichs liegt.

In einer Ausführungsform ist der erste Versorgungsanschluss mit einem Wandler verbunden. Der Wandler ist mit jeder Anschalteinheit verbunden. Der Wandler ist dazu ausgebildet, den Anschalteinheiten aus der ersten Versorgungsspannung eine Busspannung für einen Betrieb bereitzustellen. Vorteilhafterweise muss die Busspannung nicht über ein Anschlusselement in das Basismodul eingespeist werden, wenn der Wandler die Busspannung aus der ersten Versorgungsspannung generiert.

In einer Ausführungsform weist zumindest eines der Anschlusselemente einen Busspannungsanschluss zum Weiterleiten der Busspannung an ein Funktionsmodul auf. Der Wandler ist mit dem Busspannungsanschluss verbunden. Vorteilhafterweise wird die Busspannung auf diese Weise Komponenten von Funktionsmodulen bereitgestellt. Die Busspannung kann beispielsweise internen Steuereinrichtungen von Funktionsmodulen, beispielsweise Mikrocontrollern, zum Betrieb bereitgestellt werden. Interne Steuerungseinrichtungen von Funktionsmodulen können beispielsweise zum Ansteuern von Feldgeräten ausgebildet sein.

In einer Ausführungsform ist eine Überwachungseinheit an den Datenbus angebunden. Die Überwachungseinheit weist zumindest einen Sensoranschluss auf. Vorteilhafterweise ist die Überwachungseinheit dazu ausgebildet, einen Parameter, der das Basismodul betrifft, zu überwachen. Bei dem Parameter kann es sich beispielsweise um eine Temperatur im Inneren des Basismoduls, eine Temperatur außerhalb des Basismoduls, einen Luftdruck und/oder eine Luftfeuchtigkeit handeln.

Ein Funktionsmodul eines Schaltschranksystems weist ein erstes Modulanschlusselement auf, das dazu ausgebildet ist, in ein Anschlusselement eines Basismoduls einzugreifen. Das Funktionsmodul weist einen ersten Feldbusmodulanschluss auf. Das erste Modulanschlusselement weist einen ersten Moduldatenanschluss auf. Der erste Feldbusmodulanschluss ist mit dem ersten Moduldatenanschluss verbunden. Der erste Moduldatenanschluss ist dazu ausgebildet, in einen den ersten Feldbusanschluss bildenden ersten Datenanschluss eines ersten Anschlusselements des Basismoduls einzugreifen. Vorteilhafterweise ist das Funktionsmodul als Einspeisemodul zum Einspeisen von Daten in das Basismodul ausgebildet. Das Funktionsmodul ist also als Einspeisemodul ausgebildet und kann vorteilhafterweise Daten über den ersten Feldbusmodulanschluss und den ersten Moduldatenanschluss des Modulanschlusselements an das Basismodul übermitteln oder Daten vom Basismodul empfangen.

In einer Ausführungsform weist das Funktionsmodul eine weitere Anschalteinheit auf. Die weitere Anschalteinheit ist mit dem ersten Feldbusmodulanschluss und mit dem ersten Moduldatenanschluss verbunden. Die weitere Anschalteinheit ist mit einer elektronischen Schaltung verbunden. Vorteilhafterweise kann die weitere Anschalteinheit beispielsweise mit einem Netzteil der elektronischen Schaltung verbunden sein, um das Netzteil anzusteuern. Damit kann beispielsweise die erste Versorgungsspannung eingestellt werden.

In einer Ausführungsform weist das Funktionsmodul einen Modulversorgungsanschluss zum Einspeisen einer Versorgungsspannung in das Funktionsmodul auf. Der Modulversorgungsanschluss ist zum Weiterleiten der Versorgungsspannung an das Basismodul mit einem weiteren Spannungsanschluss des ersten Modulanschlusselements verbunden. Vorteilhafterweise kann die Versorgungsspannung mittels des als Einspeisemodul ausgebildeten Funktionsmoduls in das Basismodul eingespeist werden und mittels des Basismoduls weiteren Funktionsmodulen bereitgestellt werden.

In einer Ausführungsform weist das Funktionsmodul einen zweiten Feldbusmodulanschluss und ein zweites Modulanschlusselement auf. Das zweite Modulanschlusselement weist einen ersten Moduldatenanschluss auf. Der zweite Feldbusmodulanschluss ist mit dem ersten Moduldatenanschluss des zweiten Modulanschlusselements verbunden. Der erste Moduldatenanschluss des zweiten Modulanschlusselements ist dazu ausgebildet, in einen einen zweiten Feldbusanschluss bildenden ersten Datenanschluss eines zweiten Anschlusselements des Basismoduls einzugreifen. Vorteilhafterweise kann das Funktionsmodul es durch den zweiten Feldbusmodulanschluss ermöglichen, ein weiteres Basismodul an das Basismodul anzuschließen, oder die Anschalteinheiten in redundanter Art und Weise anzusprechen.

Ein Schaltschranksystem weist ein Basismodul und ein Funktionsmodul auf. Das erste Modulanschlusselement des Funktionsmoduls greift in ein erstes Anschlusselement des Basismoduls ein.

In einer Ausführungsform weist das Schaltschranksystem zumindest ein weiteres Funktionsmodul auf. Ein weiteres Modulanschlusselement des weiteren Funktionsmoduls greift in ein Anschlusselement des Basismoduls ein. Das weitere Funktionsmodul ist als Ausgabemodul ausgebildet. An das weitere Funktionsmodul können Feldgeräte angeschlossen werden. Das Schaltschranksystem bietet den Vorteil, dass im Fall eines Defekts oder eines Austauschs des weiteren Funktionsmoduls noch intakte weitere Funktionsmodule über den Datenbus angesprochen werden können. Deswegen kann das weitere Funktionsmodul im laufenden Betrieb eines das Schaltschranksystem umfassenden Automatisierungssystems ausgetauscht werden, ohne das Automatisierungssystem initialisiert zu müssen, wenn ein ersetzendes weiteres Funktionsmodul konfiguriert ist. Bei einem Einsatz des Automatisierungssystems beispielsweise in einer Produktionsmaschine kann dies einen unerwünschten Produktionsausfall verhindern.

Die oben beschriebenen Eigenschaften, Merkmale und Vorteile dieser Erfindung sowie die Art und Weise, wie diese erreicht werden, sind klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematischer Darstellung:
Fig. 1: ein erstes Basismodul gemäß einer ersten Ausführungsform für ein Schaltschranksystem in einer perspektivischen Ansicht;
Fig. 2: das erste Basismodul der Fig. 1 in einer Draufsicht;
Fig. 3: im Inneren des ersten Basismoduls angeordnete Elemente;
Fig. 4: ein zweites Basismodul gemäß einer zweiten Ausführungsform;
Fig. 5: ein drittes Basismodul gemäß einer dritten Ausführungsform;
Fig. 6: ein viertes Basismodul gemäß einer vierten Ausführungsform;
Fig. 7: ein fünftes Basismodul gemäß einer fünften Ausführungsform;
Fig. 8: ein sechstes Basismodul gemäß einer sechsten Ausführungsform;
Fig. 9: eine detaillierte Darstellung der Verbindungen einer Anschalteinheit und eines Anschlusselements eines Basismoduls;
Fig. 10: ein Funktionsmodul für ein Schaltschranksystem in einer Ansicht von Unten;
Fig. 11: das Funktionsmodul der Fig. 10 in einer Querschnittsansicht;
Fig. 12: eine perspektivische Ansicht auf ein Schaltschranksystem mit einem Basismodul und einem Einspeisemodul;
Fig. 13: das System der Fig. 12 in einer Querschnittsansicht und
Fig. 14: ein weiteres Schaltschranksystem in einer Querschnittsansicht.

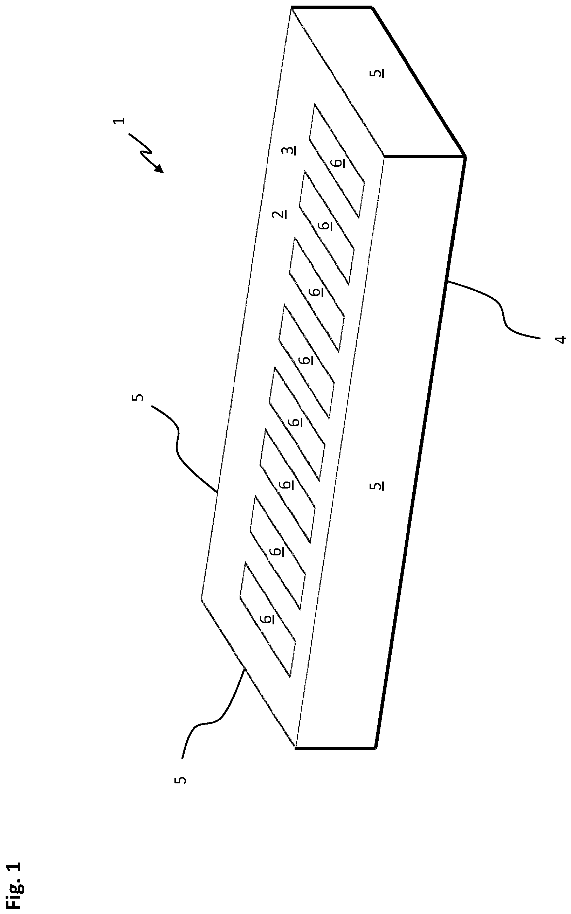

Fig. 1 zeigt schematisch ein erstes Basismodul 1 gemäß einer ersten Ausführungsform für ein Schaltschranksystem in einer perspektivischen Ansicht.

Das erste Basismodul 1 weist ein Gehäuse 2 auf. Das Gehäuse 2 kann vollständig oder zumindest bereichsweise aus einem metallischen Werkstoff, beispielsweise aus Aluminium bestehen. Das Gehäuse 2 weist eine Oberseite 3, eine der Oberseite 3 gegenüberliegende Unterseite 4 und vier Seitenwände 5 auf. Die Oberseite 3 des Gehäuses 2 weist eine Mehrzahl von Öffnungen 6 auf. Beispielhaft weist die Oberseite 3 in Fig. 1 acht Öffnungen 6 auf.

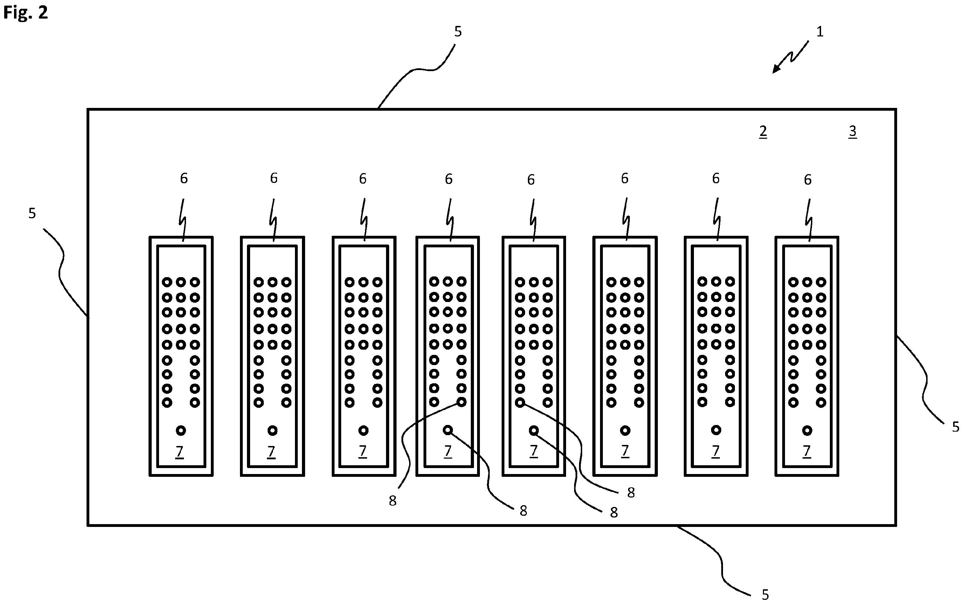

Fig. 2 zeigt schematisch das erste Basismodul 1 der Fig. 1 in einer Draufsicht.

Das erste Basismodul 1 weist eine Mehrzahl von Anschlusselementen 7 auf. Die Anschlusselemente 7 sind im Gehäuse 2 angeordnet. Jedes Anschlusselement 7 ist jeweils im Bereich einer Öffnung 6 angeordnet. Die Anschlusselemente 7 weisen Kontakte 8 auf. Beispielhaft weist jedes Anschlusselement 7 vierundzwanzig Kontakte 8 auf. Die Anschlusselemente 7 können jedoch auch eine andere Anzahl von Kontakten 8 aufweisen.

Eine Anordnung der Kontakte 8 kann von der in Fig. 2 beispielhaft gezeigten Anordnung abweichen. Eine Größe der Kontakte 8 kann ebenfalls von der in Fig. 2 angedeuteten Größe der Kontakte 8 abweichen. Die Kontakte 8 können entweder als Kontaktstifte oder als Kontaktöffnungen ausgebildet sein, sodass die Anschlusselemente 7 entweder als Einbaustecker oder als Einbaubuchsen ausgebildet sein können. Die Anschlusselemente 7 sind für eine Mehrzahl von Funktionsmodulen vorgesehen. Die Anschlusselemente 7 sind dazu ausgebildet, in Modulanschlusselemente von Funktionsmodulen einzugreifen.

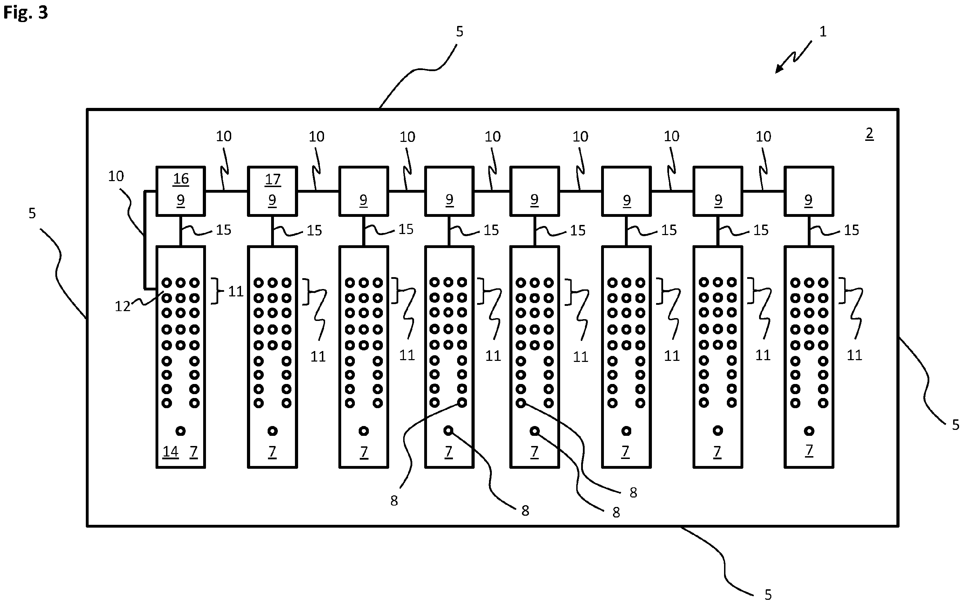

Fig. 3 zeigt schematisch das erste Basismoduls 1 in einer Draufsicht, wobei die Oberseite 3 des Gehäuses 2 nicht dargestellt ist, so dass die Elemente, die im Inneren des Gehäuses 2 angeordnet sind, zu erkennen sind.

Das Basismodul 1 weist eine Mehrzahl von Anschalteinheiten 9 auf. Die Anschalteinheiten 9 können beispielsweise als anwendungsspezifische integrierte Schaltungen (engl.: application specific integrated circuit, ASIC) ausgebildet sein. Die Anschalteinheiten 9 können auch als Slaves bezeichnet werden. Die Anschalteinheiten 9 sind durch einen Datenbus 10 miteinander verbunden. Beispielhaft sind die Anschalteinheiten 9 seriell durch den Datenbus 10 miteinander verbunden. In diesem Fall bilden die Anschalteinheiten 9 also ein Netzwerk mit einer Linientopologie. Andere Topologien, wie beispielsweise baumartige Topologien und sternförmige Topologien, sind jedoch auch möglich.

Jedes Anschlusselement 7 weist zumindest einen Datenanschluss 11 auf. Positionen der Datenanschlüsse 11 innerhalb der Anschlusselemente 7 können von den in der Fig. 3 gezeigten Positionen abweichen. Beispielsweise können die Datenanschlüsse 11 zum Austausch von auf dem EtherCAT Protokoll basierenden Daten zwischen den Anschalteinheiten 9 und Funktionsmodulen vorgesehen sein. Die Datenanschlüsse 11 für das EtherCAT Protokoll können beispielsweise jeweils sechs Kontakte 8 umfassen. Jeweils zwei Kontakte 8 der Datenanschlüsse 11 können zum differentiellen Übertragen von EtherCAT Telegrammen vorgesehen sein. Jeweils zwei Kontakte 8 der Datenanschlüsse 11 können zum differentiellen Empfangen von EtherCAT Telegrammen vorgesehen sein. Zwei weitere Kontakte 8 der Datenanschlüsse 11 können als Abschirmkontakte vorgesehen sein. Es kann auch nur ein Abschirmkontakt für einen Datenanschluss 11 vorgesehen sein. Die Abschirmkontakte können auch entfallen. Die Datenanschlüsse 11 können auch zum Austausch von Daten vorgesehen sein, die nicht dem EtherCAT Protokoll, sondern auf einem anderen Protokoll basieren. Die Daten müssen auch nicht notwendigerweise differentiell übertragen werden, stattdessen können die Datenanschlüsse 11 auch derart ausgebildet sein, dass eine serielle oder parallele Übertragung möglich ist. Es ist auch möglich, dass die Datenanschlüsse 11 derart ausgebildet sind, dass eine Datenübertragung mittels Lichtwellenleitern erfolgen kann.

Das Basismodul weist einen ersten Feldbusanschluss 12 auf. Der erste Feldbusanschluss 12 ist zum Anbinden der Anschalteinheiten 9 an einen Feldbus vorgesehen. Dazu ist der Datenbus 10 mit dem ersten Feldbusanschluss 12 verbunden. Der erste Feldbusanschluss 12 kann, wie in Fig. 3 beispielhaft gezeigt ist, durch den Datenanschluss 11 eines ersten Anschlusselements 14 gebildet werden. Der Datenanschluss 11 des ersten Anschlusselements 14 ist dazu ausgebildet, in einen ersten Moduldatenanschluss eines ersten Modulanschlusselements eines Funktionsmoduls einzugreifen. Über den ersten Feldbusanschluss 12 können beispielsweise EtherCAT Telegramme in den Datenbus 10 und die Anschalteinheiten 9 eingespeist werden. Der erste Feldbusanschluss 12 muss jedoch nicht notwendigerweise durch den Datenanschluss 11 des ersten Anschlusselements 14 gebildet werden. Der erste Feldbusanschluss 12 kann auch an einer anderen Stelle am Gehäuse 2 angeordnet bzw. ausgebildet sein.

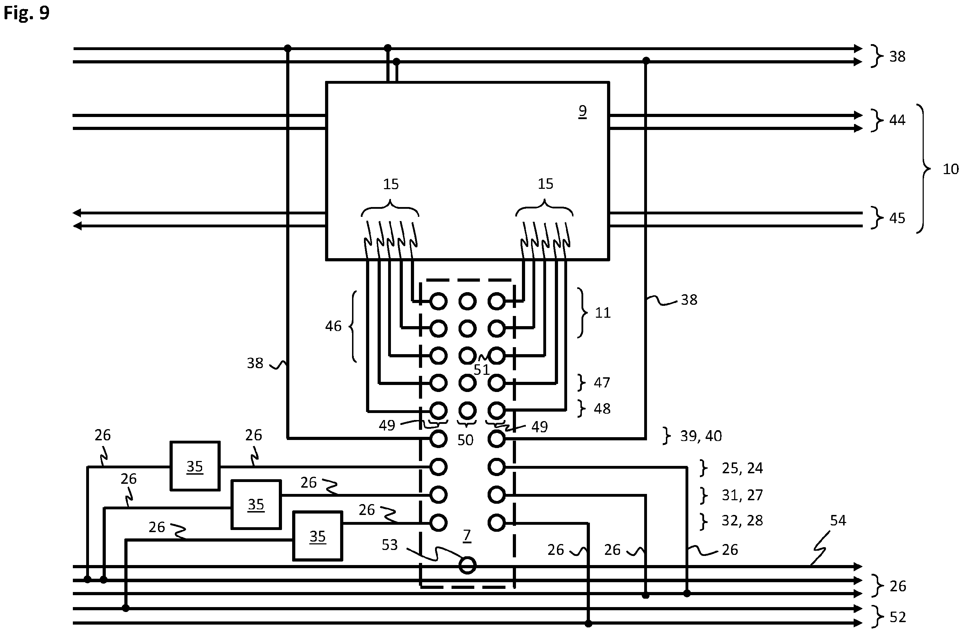

Jede Anschalteinheit 9 ist jeweils zumindest mit einem Datenanschluss 11 eines Anschlusselements 7 verbunden. Die Anschalteinheiten 9 sind mittels Datenleitungen 15 an die Datenanschlüsse 11 angebunden. Über die Datenleitungen 15 können die Anschalteinheiten 9 beispielsweise EtherCAT Daten mit Funktionsmodulen austauschen. Nicht jeder Datenanschluss 11 eines Anschlusselements 7 muss mit einer Anschalteinheit 9 verbunden sein. Wenn beispielsweise der Feldbusanschluss 12 durch den Datenanschluss 11 des ersten Anschlusselements 14 gebildet wird, so kann eine erste Anschalteinheit 16 für das erste Anschlusselement 14 auch entfallen. Ist die erste Anschalteinheit 16 hingegen im Basismodul 1 vorgesehen, so kann die erste Anschalteinheit 16 Daten, die über den den ersten Feldbusanschluss 12 bildenden Datenanschluss 11 des ersten Anschlusselements 14 und den Datenbus 10 in die erste Anschalteinheit 16 eingespeist werden, an eine zweite Anschalteinheit 17 übermitteln, ohne jedoch selbst die eingespeisten Daten zu prozessieren. Die erste Anschalteinheit 16 kann jedoch zur Kommunikation mit einem Funktionsmodul auch zumindest mit einem zweiten Datenanschluss des ersten Anschlusselements 14 verbunden sein. Der zweite Datenanschluss ist als SPI-Anschluss (Serial Peripheral Interface, SPI) ausgebildet. sein. Der zweite Datenanschluss und weitere beispielhafte Datenanschlüsse werden bei der Beschreibung der Fig. 9 genauer erläutert.

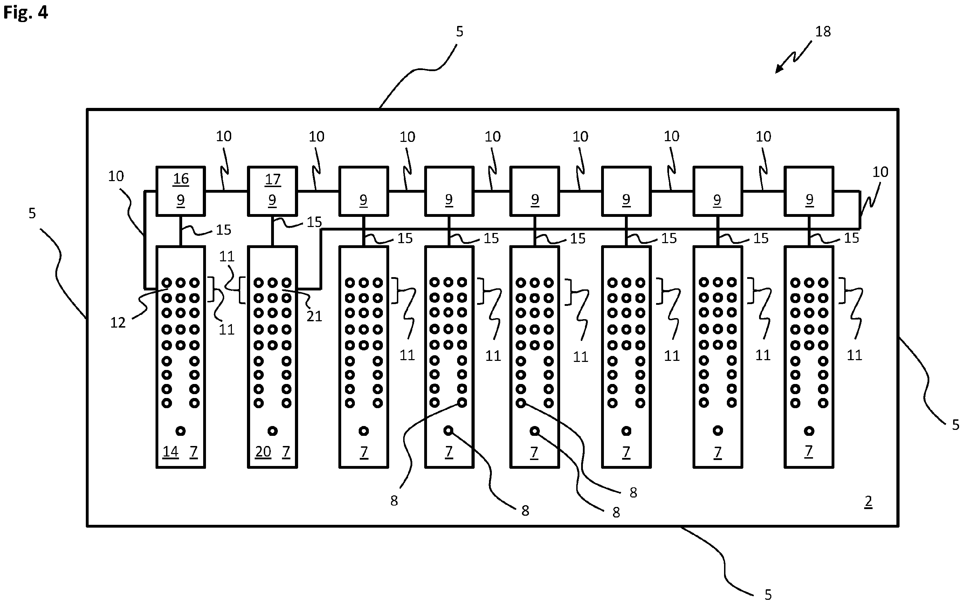

Fig. 4 zeigt schematisch ein zweites Basismodul 18 gemäß einer zweiten Ausführungsform in einer Draufsicht. Das zweite Basismodul 18 gemäß der zweiten Ausführungsform weist Ähnlichkeiten mit dem ersten Basismodul 1 gemäß der ersten Ausführungsform auf.

Ähnliche oder identische Elemente sind mit denselben Bezugszeichen versehen. In der nachfolgenden Beschreibung werden lediglich die Unterschiede beschrieben. Die Oberseite 3 des Gehäuses 2 ist nicht dargestellt, so dass die Elemente, die im Inneren des Gehäuses 2 angeordnet sind, zu erkennen sind.

Beim zweiten Basismodul 18 gemäß der zweiten Ausführungsform bildet ein Datenanschluss 11 eines zweiten Anschlusselements 20 einen zweiten Feldbusanschluss 21. Der Datenbus 10 ist mit dem zweiten Feldbusanschluss 21 verbunden. Der Datenanschluss 11 des zweiten Anschlusselements 20 ist dazu ausgebildet, in einen ersten Moduldatenanschluss eines zweiten Modulanschlusselements eines Funktionsmoduls einzugreifen. Der Datenbus 10 bildet einen Ring zwischen dem ersten Feldbusanschluss 12 und dem zweiten Feldbusanschluss 21. Zwischen dem ersten und dem zweiten Feldbusanschluss 12, 21 sind die Anschalteinheiten 9 an den Datenbus 10 angebunden. Die erste Anschalteinheit 16 und die zweite Anschalteinheit 17 können auch entfallen. Sind die erste und die zweite Anschalteinheit 16, 17 im zweiten Basismodul 18 vorgesehen, so kann die erste Anschalteinheit 16 zumindest mit dem zweiten Datenanschluss des ersten Anschlusselements 14 und die zweite Anschalteinheit 17 zumindest mit einem zweiten Datenanschluss des zweiten Anschlusselements 20, der als SPI-Anschluss ausgebildet ist, verbunden sein.

Der zweite Feldbusanschluss 21 kann beispielsweise zur redundanten Einspeisung von Daten in den Datenbus 10 vorgesehen sein. Beispielsweise können EtherCAT Telegramme über den zweiten Feldbusanschluss 21 eingespeist werden. Durch das redundante Einspeisen der Daten über den zweiten Feldbusanschluss 21, können beispielsweise bei einem Defekt einer Anschalteinheit 9 alle weiteren, intakten Anschalteinheiten 9 trotzdem angesprochen werden. Alle weiteren, intakten Anschalteinheiten 9, die zwischen dem ersten Feldbusanschluss 12 und der defekten Anschalteinheit 9 angeordnet sind, können über den ersten Feldbusanschluss 12 angesprochen werden. Alle weiteren, intakten Anschalteinheiten 9, die zwischen der defekten Anschalteinheit 9 und dem zweiten Feldbusanschluss 21 angeordnet sind, können über den zweiten Feldbusanschluss 21 angesprochen werden.

Über den ersten Feldbusanschluss 12 eingespeiste Daten können über den zweiten Feldbusanschluss 21 weitergeleitet werden. Deswegen kann der zweite Feldbusanschluss 21 beispielsweise auch dazu vorgesehen sein, Daten, die über den ersten Feldbusanschluss 12 in das zweite Basismodul 18 eingespeist werden, über den zweiten Feldbusanschluss 21 in ein zusätzliches erstes Basismodul 1 gemäß der ersten Ausführungsform oder in ein zusätzliches zweites Basismodul 18 gemäß der zweiten Ausführungsform einzuspeisen.

Der zweite Feldbusanschluss 21 kann also zum Verbinden zweier Basismodule 1, 18 verwendet werden.

Alternativ kann der zweite Feldbusanschluss 21 auch von einem Datenanschluss eines anderen Anschlusselements 7, beispielsweise von einem Datenanschluss des ersten Anschlusselements 14 gebildet werden.

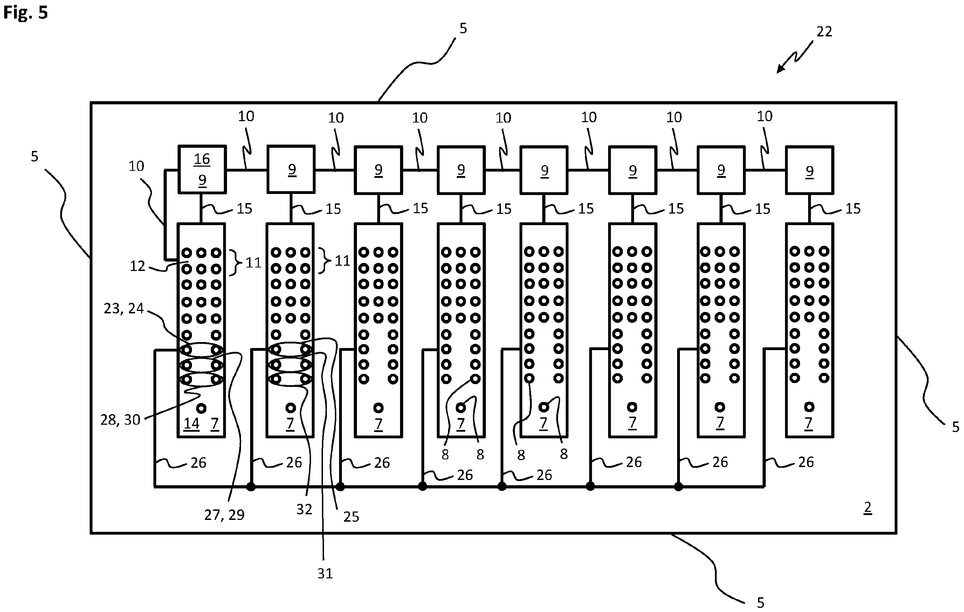

Fig. 5 zeigt schematisch ein drittes Basismodul 22 gemäß einer dritten Ausführungsform in einer Draufsicht. Das dritte Basismodul 22 gemäß der dritten Ausführungsform weist beispielhaft die Elemente des Basismoduls 1 gemäß der ersten Ausführungsform und zusätzliche Elemente auf. Ähnliche oder identische Elemente sind mit denselben Bezugszeichen versehen. Das dritte Basismodul 22 gemäß der dritten Ausführungsform kann jedoch auch die Elemente des zweiten Basismoduls 18 gemäß der zweiten Ausführungsform und die zusätzlichen Elemente aufweisen. In der nachfolgenden Beschreibung werden lediglich die zusätzlichen Elemente beschrieben. Die Oberseite 3 des Gehäuses 2 ist nicht dargestellt, so dass die Elemente, die im Inneren des Gehäuses 2 angeordnet sind, zu erkennen sind.

Beim dritten Basismodul 22 gemäß der dritten Ausführungsform bildet ein erster Spannungsanschluss 23 eines der Anschlusselemente 7 einen ersten Versorgungsanschluss 24 zum Einspeisen einer ersten Versorgungsspannung in das dritte Basismodul 22. Beispielhaft ist in Fig. 5 gezeigt, dass der erste Versorgungsanschluss 24 am ersten Anschlusselement 14 vorgesehen ist. Der erste Versorgungsanschluss 24 kann beispielsweise zum Einspeisen einer Gleichspannung von 24V vorgesehen sein. Zumindest eines der übrigen Anschlusselemente 7 weist einen weiteren ersten Spannungsanschluss 25 zum Weiterleiten der ersten Versorgungsspannung an ein Funktionsmodul auf. In Fig. 5 ist der weitere erste Spannungsanschluss 25 nur für ein Anschlusselement 7 beispielhaft gezeigt. Selbstverständlich können auch alle übrigen Anschlusselemente 7 einen weiteren ersten Spannungsanschluss 25 aufweisen, bis auf das erste Anschlusselement 14. Der erste Versorgungsanschluss 24 ist mit den weiteren ersten Spannungsanschlüssen 25 mittels einer Versorgungsleitung 26 verbunden. Der Einfachheit halber ist in Fig. 5 die Versorgungsleitung 26 nur mit einem Kontakt 8 des ersten Versorgungsanschlusses 24 und jeweils nur mit einem Kontakt 8 eines weiteren ersten Spannungsanschlusses 25 verbunden dargestellt. Ein Massepfad der Versorgungsleitung 26, der mit einem weiteren Kontakt 8 des Versorgungsanschlusses 24 bzw. mit einem weiteren Kontakt 8 der weiteren ersten Spannungsanschlüsse 25 verbunden ist, ist in Fig. 5 nicht gezeigt.

Alternativ kann der erste Versorgungsanschluss auch an einer anderen Stelle am Gehäuse 2 angeordnet bzw. ausgebildet sein. In diesem Fall weist zumindest ein Anschlusselement 7 und/oder das erste Anschlusselement 14 einen weiteren ersten Spannungsanschluss 25 zum Weiterleiten der ersten Versorgungsspannung an ein Funktionsmodul auf.

Das dritte Basismodul 22 kann auch weitere Versorgungsanschlüsse 27, 28 aufweisen. Beispielsweise kann das dritte Basismodul 22 insgesamt drei Versorgungsanschlüsse 24, 27, 28 aufweisen. Ein zweiter Versorgungsanschluss 27 und ein dritter Versorgungsanschluss 28 können beispielsweise jeweils von einem zweiten Spannungsanschluss 29 und einem dritten Spannungsanschluss 30 eines der Anschlusselemente 7 gebildet werden. In Fig. 5 ist dies beispielhaft für das erste Anschlusselement 14 gezeigt. Zumindest eines der übrigen Anschlusselemente 7 weist dann einen weiteren zweiten Spannungsanschluss 31 zum Weiterleiten einer zweiten Versorgungsspannung an ein Funktionsmodul auf und zumindest eines der übrigen Anschlusselemente 7 weist einen weiteren dritten Spannungsanschluss 32 zum Weiterleiten einer dritten Versorgungsspannung an ein Funktionsmodul auf. In Fig. 5 ist der weitere zweite Spannungsanschluss 31 und der weitere dritte Spannungsanschluss 32 nur für ein Anschlusselement 7 beispielhaft gezeigt. Selbstverständlich können auch alle übrigen Anschlusselemente 7 einen weiteren zweiten Spannungsanschluss 31 und einen weiteren dritten Spannungsanschluss 32 aufweisen, bis auf das erste Anschlusselement 14. In Fig. 5 sind Versorgungsleitungen zwischen dem zweiten Versorgungsanschluss 27 und dem weiteren zweiten Spannungsanschluss 31 bzw. zwischen dem dritten Versorgungsanschluss 28 und dem weiteren dritten Spannungsanschluss 32 der Einfachheit halber nicht dargestellt.

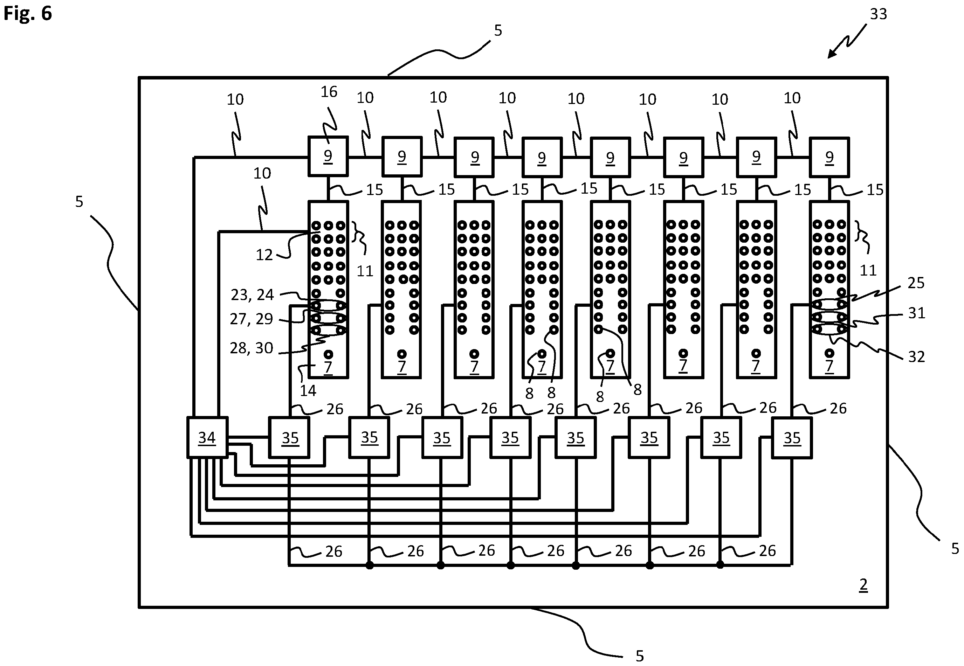

Der zweite Versorgungsanschluss 27 kann beispielsweise zum geschalteten Einspeisen einer Gleichspannung von 24V vorgesehen sein. Der dritte Versorgungsanschluss 28 kann beispielsweise zum Einspeisen einer Gleichspannung von 48V vorgesehen sein. Bei den Versorgungsspannungen muss es sich jedoch nicht notwendigerweise um Gleichspannungen handeln. Neben Kleinspannungen können auch Niederspannungen als Versorgungsspannungen in das dritte Basismodul 22 eingespeist werden. Die Versorgungsspannungen können über die weiteren Spannungsanschlüsse 25, 31, 32 an Funktionsmodule weitergeleitet werden. Die Versorgungsspannungen können dann über die Funktionsmodule Teilnehmern im Feld, wie beispielsweise Sensoren und Aktoren, für ihren Betrieb bereitgestellt werden. Der zweite und der dritte Versorgungsanschluss 27, 28 und die weiteren zweiten und dritten Spannungsanschlüsse 31, 32 können jedoch auch entfallen. Fig. 6 zeigt schematisch ein viertes Basismodul 33 gemäß einer vierten Ausführungsform in einer Draufsicht. Das vierte Basismodul 33 gemäß der vierten Ausführungsform weist die Elemente des dritten Basismoduls 22 gemäß der dritten Ausführungsform und zusätzliche Elemente auf. Ähnliche oder identische Elemente sind mit denselben Bezugszeichen versehen. In der nachfolgenden Beschreibung werden lediglich die zusätzlichen Elemente beschrieben. Die Oberseite 3 des Gehäuses 2 ist nicht dargestellt, so dass die Elemente, die im Inneren des Gehäuses 2 angeordnet sind, zu erkennen sind.

Das vierte Basismodul 33 gemäß der vierten Ausführungsform weist eine an den Datenbus 10 angebundene Sicherungseinrichtung 34 auf. Die Sicherungseinrichtung 34 ist zumindest mit einer Sicherungsschaltung 35 verbunden. In Fig. 6 ist beispielhaft gezeigt, dass die Sicherungseinrichtung 34 mit jeweils einer Sicherungsschaltung 35 pro Anschlusselement 7 verbunden ist. Die Sicherungsschaltungen 35 sind über die Versorgungsleitung 26 jeweils mit dem ersten Versorgungsanschluss 24 verbunden. Die Sicherungsschaltungen 35 sind zum abgesicherten Weiterleiten der ersten Versorgungsspannung an ein Funktionsmodul mit den weiteren ersten Spannungsanschlüssen 25 verbunden.

Die Sicherungseinrichtung 34 kann beispielsweise Mittel zum Erfassen der ersten Versorgungsspannung aufweisen und ist dazu ausgebildet, die erfassten Daten auszuwerten. Die Sicherungsschaltungen 35 können beispielsweise Feldeffekttransistoren aufweisen, die von der Sicherungseinrichtung 34 steuerbar sind. Stellt die Sicherungseinrichtung 34 beispielsweise fest, dass die erste Versorgungsspannung außerhalb eines vorgegebenen Wertebereichs liegt, kann die Sicherungseinrichtung 34 die Feldeffekttransistoren der Sicherungsschaltungen 35 derart ansteuern, dass die erste Versorgungsspannung nicht weitergeleitet werden kann. Mittels der Sicherungseinrichtung 34 und den Feldeffekttransistoren ist auch ein geschaltetes Weiterleiten der ersten Versorgungsspannung möglich.

Die Sicherungseinrichtung 34 ist in Fig. 6 beispielhaft zwischen dem ersten Feldbusanschluss 12 und den Anschalteinheiten 9 an den Datenbus 10 angebunden. Die Sicherungseinrichtung 34 kann jedoch auch an einer anderen Position an den Datenbus 10 angebunden sein. Beispielsweise kann die Sicherungseinrichtung 34 zwischen zwei Anschalteinheiten 9 an den Datenbus 10 angebunden sein.

In Fig. 6 sind der Übersicht wegen, lediglich die Sicherungsschaltungen 35 zum abgesicherten Weiterleiten der ersten Versorgungsspannung dargestellt. Es können jedoch auch zusätzliche Sicherungsschaltungen 35 zum abgesicherten Weiterleiten der zweiten und dritten Versorgungsspannung vorgesehen sein. Zum abgesicherten Weiterleiten der zweiten Versorgungsspannung, ist zumindest eine zusätzliche Sicherungsschaltung 35 mit dem zweiten Versorgungsanschluss 27 und mit einem weiteren zweiten Spannungsanschluss 31 zu verbinden. Zum abgesicherten Weiterleiten der dritten Versorgungsspannung, ist zumindest eine zusätzliche Sicherungsschaltung 35 mit dem dritten Versorgungsanschluss 28 und mit einem weiteren dritten Spannungsanschluss 31 zu verbinden. Die zusätzlichen Sicherungsschaltungen 35 können jedoch auch entfallen.

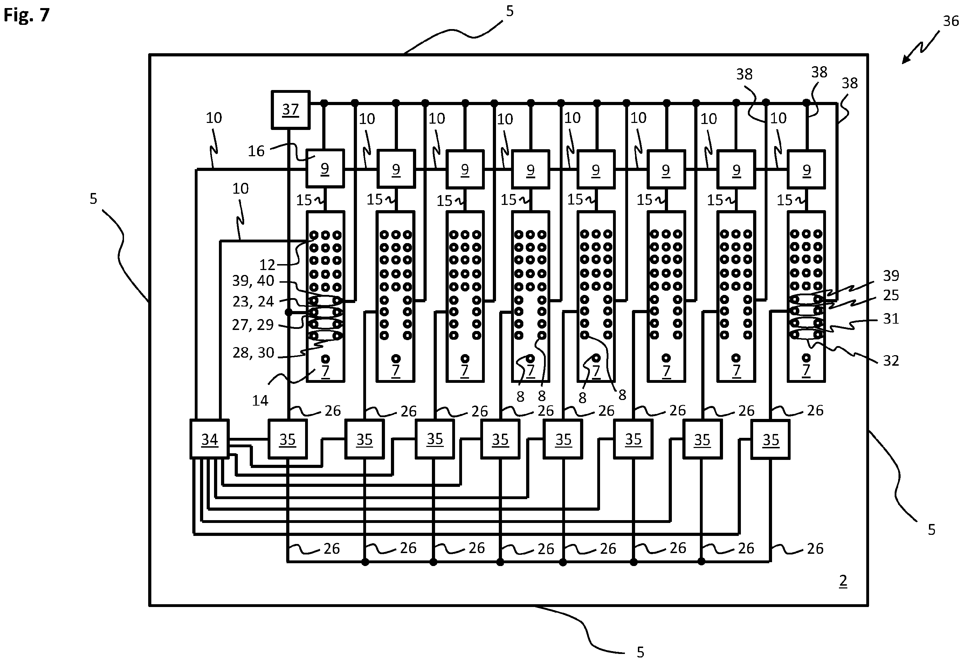

Fig. 7 zeigt schematisch ein fünftes Basismodul 36 gemäß einer fünften Ausführungsform in einer Draufsicht. Das fünfte Basismodul 36 gemäß der fünften Ausführungsform weist die Elemente des vierten Basismoduls 33 gemäß der vierten Ausführungsform und zusätzliche Elemente auf. Ähnliche oder identische Elemente sind mit denselben Bezugszeichen versehen. In der nachfolgenden Beschreibung werden lediglich die zusätzlichen Elemente beschrieben. Die Oberseite 3 des Gehäuses 2 ist nicht dargestellt, so dass die Elemente, die im Inneren des Gehäuses 2 angeordnet sind, zu erkennen sind.

Der erste Versorgungsanschluss 24 ist mit einem Wandler 37 verbunden. Der Wandler 37 ist durch eine Busversorgungsleitung 38 mit jeder Anschalteinheit 9 verbunden. Der Einfachheit halber ist in Fig. 7 ein Massepfad der Busversorgungsleitung 38 nicht dargestellt. Der Wandler 37 ist dazu ausgebildet, den Anschalteinheiten 9 aus der ersten Versorgungsspannung eine Busspannung für einen Betrieb zu generieren und bereitzustellen. Die Busspannung kann beispielsweise eine Gleichspannung von 3,3V sein.

Zumindest eines der Anschlusselemente 7 weist einen Busspannungsanschluss 39 zum Weiterleiten der Busspannung an ein Funktionsmodul auf. In Fig. 7 ist beispielhaft gezeigt, dass das erste Anschlusselemente 14 und das ganz rechte Anschlusselement 7 jeweils einen Busspannungsanschluss 39 aufweisen. Es können jedoch auch alle Anschlusselemente 7 einen Busspannungsanschluss 39 aufweisen. Der Wandler 37 ist mit den Busspannungsanschlüssen 39 verbunden. Dadurch kann die Busspannung über die Busspannungsanschlüsse 39 an Funktionsmodule weitergeleitet werden. In einem Funktionsmodul kann die Busspannung beispielsweise weiteren Anschalteinheiten oder beispielsweise einem Mikrocontroller für einen Betrieb bereitgestellt werden. Der Wandler 37 muss jedoch nicht zwingenderweise mit den Busanschlüssen 39 verbunden sein, wenn dies nicht zweckmäßig ist.

Alternativ kann auch ein Busspannungsanschluss 39 eines der Anschaltelemente 7 einen Busversorgungsanschluss 40 zum Einspeisen der Busspannung in das fünfte Basismodul 36 für einen Betrieb der Anschalteinheiten 9 bilden. In Fig. 7 ist beispielhaft gezeigt, dass der Busversorgungsanschluss 40 durch den Busspannungsanschluss 39 des ersten Anschlusselements 14 gebildet wird. In diesem Fall kann der Wandler 37 entfallen und jede Anschalteinheit 9 ist durch die Busversorgungsleitung 38 mit dem Busversorgungsanschluss 40 verbunden. Die Busspannung kann beispielsweise von einem Funktionsmodul bereitgestellt werden und über den Busversorgungsanschluss 40 in das fünfte Basismodul 36 eingespeist werden. Zusätzlich kann der Busversorgungsanschluss 40 zumindest mit einem Busspannungsanschluss 39 der übrigen Anschlusselemente 9 verbunden sein.

Statt eines Wandlers 37 kann das fünfte Basismodul 36 auch eine Mehrzahl von Wandlern 37 aufweisen. Beispielsweise kann jeweils für eine Gruppe von Anschalteinheiten 9 jeweils ein Wandler 37 im fünften Basismodul 36 angeordnet sein.

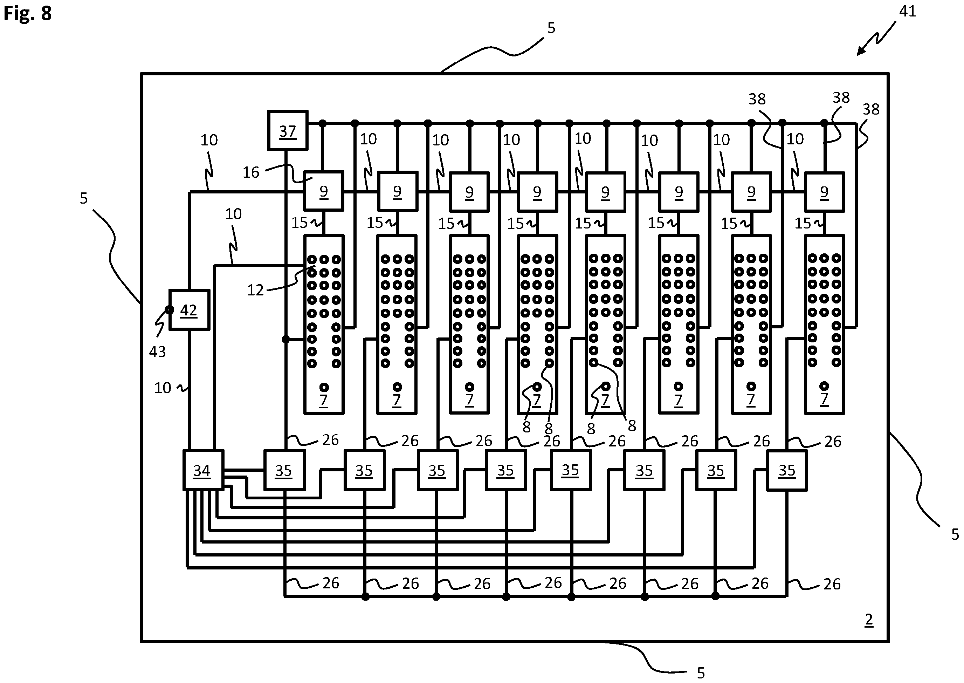

Fig. 8 zeigt schematisch ein sechstes Basismodul 41 gemäß einer sechsten Ausführungsform in einer Draufsicht. Das sechste Basismodul 41 gemäß der sechsten Ausführungsform weist beispielhaft die Elemente des fünften Basismoduls 36 gemäß der fünften Ausführungsform und zusätzliche Elemente auf. Ähnliche oder identische Elemente sind mit denselben Bezugszeichen versehen. Das sechste Basismodul 41 gemäß der sechsten Ausführungsform kann jedoch auch die Elemente des ersten Basismoduls 1 gemäß der ersten Ausführungsform, des zweiten Basismoduls 18 gemäß der zweiten Ausführungsform, des dritten Basismoduls 22 gemäß der dritten Ausführungsform oder des vierten Basismoduls 33 gemäß der vierten Ausführungsform und die zusätzlichen Elemente aufweisen. In der nachfolgenden Beschreibung werden lediglich die zusätzlichen Elemente beschrieben. Die Oberseite 3 des Gehäuses 2 ist nicht dargestellt, so dass die Elemente, die im Inneren des Gehäuses 2 angeordnet sind, zu erkennen sind.

Beim sechsten Basismodul 41 gemäß der sechsten Ausführungsform ist eine Überwachungseinheit 42 an den Datenbus 10 angebunden. Die Überwachungseinheit 42 ist in Fig. 8 beispielhaft zwischen der Sicherungseinrichtung 34 und den Anschalteinheiten 9 an den Datenbus 10 angebunden. Die Überwachungseinheit 42 kann jedoch auch an einer anderen Position an den Datenbus 10 angebunden sein. Beispielsweise kann die Überwachungseinheit 42 zwischen dem ersten Feldbusanschluss 12 und der Sicherungseinrichtung 34 oder zwischen zwei Anschalteinheiten 9 an den Datenbus 10 angebunden sein.

Die Überwachungseinheit 42 ist dazu ausgebildet, zumindest einen Parameter, der das sechste Basismodul 41 betrifft, zu überwachen. Bei dem Parameter kann es sich beispielsweise um eine Temperatur im Inneren des Gehäuses 2, eine Temperatur in einer Umgebung des sechsten Basismoduls 41, einen Druck, eine Luftfeuchtigkeit, eine Neigung des sechsten Basismoduls 41 oder eine Beschleunigung des sechsten Basismoduls 41 handeln. Dazu weist die Überwachungseinheit 42 zumindest einen Sensoranschluss 43 auf. Am Sensoranschluss 43 kann ein Sensor angeschlossen sein, der den Parameter erfasst.

Fig. 9 zeigt schematisch eine detaillierte Darstellung der Verbindungen einer Anschalteinheit 9 und eines Anschlusselementes 7 des sechsten Basismoduls 41. Die dargestellten und beschriebenen Verbindungen und Anschlüsse der Anschalteinheit 9 und des Anschlusselementes 7 sind analog übertragbar auf das erste Basismodul 1 gemäß der ersten Ausführungsform, das zweite Basismoduls 18 gemäß der zweiten Ausführungsform, das dritte Basismoduls 22 gemäß der dritten Ausführungsform, das vierte Basismoduls 33 gemäß der vierten Ausführungsform oder das fünfte Basismodul 36 gemäß der fünften Ausführungsform, wobei die in der jeweiligen Ausführungsform nicht benötigten Verbindungen und Anschlüsse weggelassen bzw. nicht genutzt werden können.

Die Anschalteinheit 9 ist an die Busversorgungsleitung 38 angeschlossen. In der detaillierten Darstellung der Fig. 9 ist die Busversorgungsleitung 38 mit ihrer Masseleitung gezeigt. Die Anschalteinheit 9 ist ferner mit dem Datenbus 10 verbunden. Der Datenbus 10 umfasst zwei Kanäle 44, 45 für einen bidirektionalen Austausch von Daten mit anderen Anschalteinheiten 9. Der erste und der zweite Kanal 44, 45 des Datenbusses 10 sind jeweils durch einen Doppelpfeil in Fig. 9 dargestellt.

Das Anschlusselement 7 weist beispielhaft vier Datenanschlüsse 11, 46, 47, 48 auf. Eine Anordnung der Datenanschlüsse 11, 46, 47, 48 kann von der in Fig. 9 dargestellten Anordnung abweichen. Auch ist eine Belegung der Kontakte nicht festgelegt, sondern änderbar. Drei der vier Datenanschlüsse 11, 46, 47, 48 können auch entfallen.

Der erste Datenanschluss 11 ist als EtherCAT Anschluss mit vier Signalkontakten 49 und zwei optionalen Abschirmkontakten 50 ausgebildet.

Der zweite Datenanschluss 46 ist als SPI-Anschluss ausgebildet. Ein SPI-Anschluss weist insgesamt fünf Signalkontakte 49 auf, die als SEL-, CLK-, DI-, DO-, und IRQ-Kontakte bezeichnet werden können. Der als Interrupteingang ausgebildete IRQ-Kontakt kann auch entfallen. Der SEL-Kontakt und der DO-Kontakt und/oder der DI-Kontakt können ebenfalls entfallen. Ein zusätzlicher sechster Kontakt 51 kann es ermöglichen abzufragen, ob ein elektrisch löschbar programmierbarer Nur-Lese-Speicher (engl.:Electrically Erasable Programmable Read-Only Memory, EEPROM) eines Funktionsmoduls betriebsbereit ist. Für jeweils zwei Signalkontakte 49 kann der SPI-Anschluss 46 ebenfalls einen Abschirmkontakt 50 aufweisen. Es kann jedoch auch nur ein Abschirmkontakt 50 genügen. Die Abschirmkontakte 50 können beim SPI-Anschluss jedoch auch entfallen. Neben dem SPI-Anschluss kann das Anschlusselement 7 auch einen QSPI-Anschluss (queued SPI) aufweisen.

Der zur Kommunikation mittels EtherCAT vorgesehene erste Datenanschluss 11 und der zur Kommunikation mittels SPI vorgesehene zweite Datenanschluss 46 weisen in der beispielhaften Darstellung der Fig. 9 vier gemeinsame Signalkontakte 49 und zwei gemeinsame Abschirmkontakte 50 auf. Die zwei gemeinsamen Abschirmkontakte 50 können auch entfallen. Der erste Datenanschluss 11 und der zweite Datenanschluss 46 müssen nicht zwingenderweise gemeinsame Signalkontakte 49 und gemeinsame Abschirmkontakte 50 aufweisen.

Zur Kommunikation der Anschalteinheit 9 mit einem in einem Funktionsmodul angeordneten elektrisch löschbar programmierbaren Nur-Lese-Speicher (EEPROM) ist ein dritter Datenanschluss 47 mit zwei Signalkontakten 49 und einem optionalen Abschirmkontakt 50 vorgesehen. Der dritten Anschluss 47 kann auch als I²C-Anschluss (Inter-Integrated Circuit Anschluss) bezeichnet werden. Einer der Signalkontakte 49 kann auch dazu dienen, die Betriebsbereitschaft des EEPROM abzufragen.

Ein vierter Datenanschluss 48 ist zum Übertragen von Synchronisationssignalen vorgesehen. Ein erster Signalkontakt 49 des vierten Datenanschlusses 48 kann als Latch-0-Kontakt bezeichnet werden. Ein zweiter Signalkontakt 49 des vierten Datenanschlusses 48 kann als Latch-1-Kontakt bezeichnet werden. Der vierte Datenanschluss 48 umfasst ebenfalls einen optionalen Abschirmkontakt 50.

Das Anschlusselement 7 weist den Busspannungsanschluss 39 auf, der auch als Busversorgungsanschluss 40 vorgesehen sein kann. Entgegen der Darstellung der Fig. 9 muss der Busspannungsanschluss 39 nicht notwendigerweise mit der Busversorgungsleitung 38 verbunden sein.

Weiter weist das Anschlusselement 7 den weiteren ersten, den weiteren zweiten und den weiteren dritten Spannungsanschluss 25, 31, 32 auf, die jeweils entweder als erster, zweiter und dritter Versorgungsanschluss 24, 27, 28 oder zum Weiterleiten der ersten, zweiten und dritten Versorgungsspannung an ein Funktionsmodul vorgesehen sein können.

Beispielhaft ist neben dem weiteren ersten Spannungsanschluss 25 auch der weitere zweite Spannungsanschluss 31 mit der Versorgungsleitung 26 verbunden. In der detaillierten Darstellung der Fig. 9 ist die Versorgungsleitung 26 mit ihrem Massepfad dargestellt. Für den weiteren zweiten Spannungsanschluss 31 kann jedoch auch eine separate Versorgungsleitung vorgesehen sein. Der weitere dritte Spannungsanschluss 32 ist mit einer weiteren Versorgungsleitung 52 verbunden.

Optional weist das Anschlusselement 7 einen Schutzkontakt 53 auf, der mit einem Schutzleitersystem 54 verbunden ist und dem Schutz vor Stromschlägen dient.

Der weitere erste, der weitere zweite, der weitere dritte Spannungsanschluss 25, 31, 32, der Busspannungsanschluss 39, die Versorgungsleitung 26, die weitere Versorgungsleitung 52 und die in Fig. 9 dargestellten Sicherungsschaltungen 35 können auch entfallen.

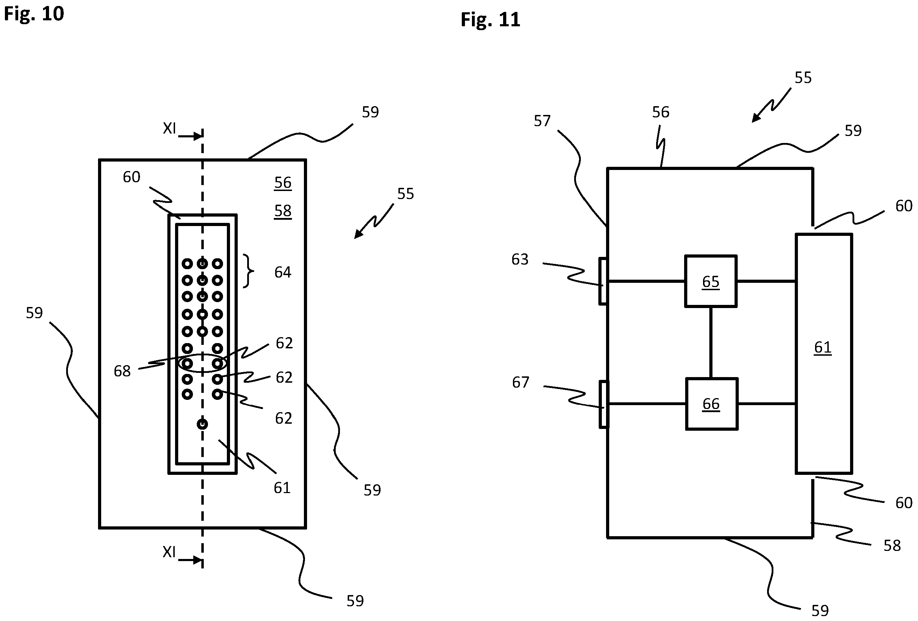

Fig. 10 zeigt schematisch ein Funktionsmodul 55 für ein Schaltschranksystem in einer Ansicht von Unten.

Das Funktionsmodul 55 weist ein Modulgehäuse 56 auf. Das Modulgehäuse 56 kann vollständig oder zumindest bereichsweise aus einem metallischen Werkstoff, beispielsweise aus Aluminium bestehen. Jedoch ist auch jeder andere Werkstoff denkbar. Das Modulgehäuse 56 weist eine hier nicht sichtbare Oberseite 57, eine der Oberseite 57 gegenüberliegende Unterseite 58 und vier Seitenwände 59 auf. Die Unterseite 58 des Modulgehäuses 56 weist eine Öffnungen 60 auf.

Das Funktionsmodul 55 weist ein erstes Modulanschlusselement 61 auf. Das erste Modulanschlusselement 61 ist zum Teil im Modulgehäuse 56 angeordnet. Das erste Modulanschlusselement 61 ist im Bereich der Öffnung 60 angeordnet und ragt aus der Öffnung 60 heraus. Das erste Modulanschlusselement 61 weist Kontakte 62 auf. Beispielhaft weist das erste Modulanschlusselement 61 vierundzwanzig Kontakte 62 auf. Das erste Modulanschlusselement 61 kann jedoch auch eine andere Anzahl an Kontakten 62 aufweisen. Die Kontakte 62 des ersten Modulanschlusselements 61 können entweder als Kontaktstifte oder als Kontaktöffnungen ausgebildet sein, so dass das erste Modulanschlusselement 61 entweder als Einbaustecker oder als Einbaubuchse ausgebildet sein kann. Das erste Modulanschlusselement 61 ist dazu ausgebildet, in ein Anschlusselement 7 des ersten Basismoduls 1 gemäß der ersten Ausführungsform, des zweiten Basismoduls 18 gemäß der zweiten Ausführungsform, des dritten Basismoduls 22 gemäß der dritten Ausführungsform, des vierten Basismoduls 33 gemäß der vierten Ausführungsform, des fünften Basismoduls 36 gemäß der fünften Ausführungsform oder des sechsten Basismoduls 41 gemäß der sechsten Ausführungsform entsprechend der vorstehenden Beschreibung zu den Figuren 1 bis 9 einzugreifen.

Fig. 11 zeigt schematisch das Funktionsmodul 55 der Fig. 10 in einer Querschnittsansicht auf eine in Fig. 10 dargestellte Ebene XI-XI, die mittels einer gestrichelten Linie angedeutet ist.

Das Funktionsmodul 55 ist als Einspeisemodul ausgebildet und weist einen ersten Feldbusmodulanschluss 63 auf. Der erste Feldbusmodulanschluss 63 ist an der Oberseite 57 des Modulgehäuses 56 angeordnet. Das erste Modulanschlusselement 61 weist einen in Fig. 10 dargestellten ersten Moduldatenanschluss 64 auf. Der erste Feldbusmodulanschluss 63 ist mit dem ersten Moduldatenanschluss 64 verbunden. Der erste Moduldatenanschluss 64 ist dazu vorgesehen, in den den ersten Feldbusanschluss 12 bildenden ersten Datenanschluss 11 des ersten Anschlusselements 14 des ersten Basismoduls 1 gemäß der ersten Ausführungsform, des zweiten Basismoduls 18 gemäß der zweiten Ausführungsform, des dritten Basismoduls 22 gemäß der dritten Ausführungsform, desvierten Basismoduls 33 gemäß der vierten Ausführungsform, des fünften Basismoduls 36 gemäß der fünften Ausführungsform oder des sechsten Basismoduls 41 gemäß der sechsten Ausfü h ru ngsformeinzugreifen.

Gemäß einer Ausführungsform kann das Funktionsmodul 55 eine weitere Anschalteinheit 65 aufweisen. Die weitere Anschalteinheit 65 ist mit dem ersten Feldbusmodulanschluss 63 und mit dem Moduldatenanschluss 64 verbunden. Die weitere Anschalteinheit 65 ist auch mit einer elektronischen Schaltung 66 verbunden. Die elektronische Schaltung 66 kann beispielsweise Schalter, Sicherungen, einen Blitzschutz, einen Netzfilter, ein Netzschütz, eine Netzdrossel, ein Strom- und ein Spannungsmessgerät und/oder ein Netzteil umfassen. Die weitere Anschalteinheit 65 kann beispielsweise mit dem Netzteil der elektronischen Schaltung 66 verbunden sein, um das Netzteil anzusteuern. Die weitere Anschalteinheit 65 kann jedoch auch entfallen. In diesem Fall kann beispielsweise die erste Anschalteinheit 16 des ersten Basismoduls 1 gemäß der ersten Ausführungsform, des zweiten Basismoduls 18 gemäß der zweiten Ausführungsform, des dritten Basismoduls 22 gemäß der dritten Ausführungsform, des vierten Basismoduls 33 gemäß der vierten Ausführungsform, des fünften Basismoduls 36 gemäß der fünften Ausführungsform oder des sechsten Basismoduls 41 gemäß der sechsten Ausführungsformdazu ausgebildet sein, über einen SPI-Anschluss 46 des ersten Anschlusselements 14 und über einen entsprechenden SPI-Modulanschluss des ersten Modulanschlusselements 61 mit dem Netzteil des Funktionsmoduls 55 verbunden ist, um es anzusteuern.

Das Funktionsmodul 55 weist einen Modulversorgungsanschluss 67 zum Einspeisen einer Versorgungsspannung in das Funktionsmodul 55 auf. Der Modulversorgungsanschluss 67 ist zum Weiterleiten der Versorgungsspannung an das erste Basismodul 1 gemäß der ersten Ausführungsform, das zweite Basismodul 18 gemäß der zweiten Ausführungsform, das dritte Basismodul 22 gemäß der dritten Ausführungsform, das vierte Basismodul 33 gemäß der vierten Ausführungsform, das fünfte Basismoduls 36 gemäß der fünften Ausführungsform oder das sechste Basismoduls 41 gemäß der sechsten Ausführungsform mit einem in Fig. 10 dargestellten Spannungsanschluss 68 des ersten Modulanschlusselements 61 verbunden. Der Modulversorgungsanschluss 67 ist mit der elektronischen Schaltung 66 verbunden, während die elektronische Schaltung 66 mit dem Spannungsanschluss 68 verbunden ist. Der Spannungsanschluss 68 ist dazu ausgebildet in einen Versorgungsanschluss 24, 27, 28 des ersten Basismoduls 1 gemäß der ersten Ausführungsform, des zweiten Basismoduls 18 gemäß der zweiten Ausführungsform, des dritten Basismoduls 22 gemäß der dritten Ausführungsform, des vierten Basismoduls 33 gemäß der vierten Ausführungsform, des fünften Basismoduls 36 gemäß der fünften Ausführungsform oder des sechsten Basismoduls 41 gemäß der sechsten Ausführungsform einzugreifen. Die elektronische Schaltung 66, der Modulversorgungsanschluss 67 und der Spannungsanschluss 68 können jedoch auch entfallen. Bei der in Fig. 10 beispielhaft gewählten Anordnung des Spannungsanschlusses 68 würde dieser in den ersten Versorgungsanschluss 24 eingreifen.

Der erste Feldbusmodulanschluss 63 und der Modulversorgungsanschluss 67 können optional auch einen gemeinsamen Anschluss bilden. Über den gemeinsamen Anschluss können Daten und Versorgungsspannungen in das Funktionsmodul 55 eingespeist werden. In diesem Fall weist das Funktionsmodul 55 eine Entkoppelungseinrichtung auf. Die Entkoppelungseinrichtung ist mit dem gemeinsamen Anschluss, mit dem ersten Moduldatenanschluss 64 und mit dem Spannungsanschluss 68 des ersten Modulanschlusselements 61 verbunden. Die Entkoppelungseinrichtung ist dazu ausgebildet, die über den gemeinsamen Anschluss in das Funktionsmodul 55 eingespeisten Daten und Versorgungsspannungen voneinander zu entkoppeln. Beispielsweise können auf einer vieradrigen Leitung sowohl EtherCAT Daten, als auch zwei Versorgungsspannungen übertragen werden. Diese können von der Entkoppelungseinrichtung voneinander entkoppelt werden, so dass Daten und Versorgungsspannungen getrennt voneinander über das erste Modulanschlusselement 61 und ein Anschlusselement 7 des ersten Basismoduls 1 gemäß der ersten Ausführungsform, des zweiten Basismoduls 18 gemäß der zweiten Ausführungsform, des dritten Basismoduls 22 gemäß der dritten Ausführungsform, des vierten Basismoduls 33 gemäß der vierten Ausführungsform, des fünften Basismoduls 36 gemäß der fünften Ausführungsform oder des sechsten Basismoduls 41 gemäß der sechsten Ausführungsform in das jeweilige Basismodul eingespeist werden können.

In einer nicht dargestellten Ausführungsform kann das Funktionsmodul 55 einen zweiten Feldbusmodulanschluss und ein zweites Modulanschlusselement aufweisen. Das zweite Modulanschlusselement weist einen ersten Moduldatenanschluss auf. Der zweite Feldbusmodulanschluss ist mit dem ersten Moduldatenanschluss des zweiten Modulanschlusselements verbunden. Der erste Moduldatenanschluss des zweiten Modulanschlusselements des Funktionsmoduls 55 ist dazu ausgebildet, in einen den zweiten Feldbusanschluss 21 bildenden ersten Datenanschluss 11 des zweiten Anschlusselements 20 des zweiten Basismoduls 18 gemäß der zweiten Ausführungsform einzugreifen.

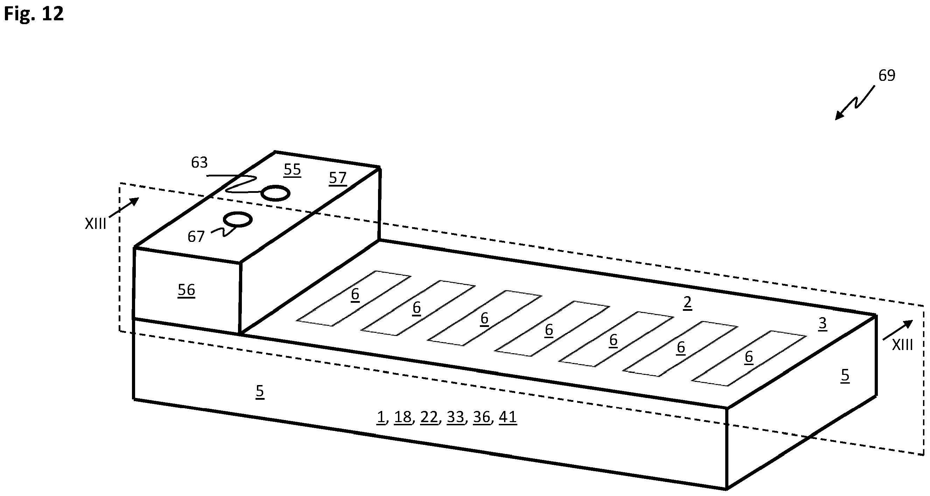

Fig. 12 zeigt schematisch eine perspektivische Ansicht auf ein Schaltschranksystem 69 mit dem Basismodul 1, dem zweiten Basismodul 18, dem dritten Basismodul 22, dem vierten Basismodul 33, dem fünften Basismodul 36 oder dem sechsten Basismodul 41 gemäß einer der zu den Fig. 1 bis 9 beschriebenen sechs Ausführungsformen und dem als Einspeisemodul ausgebildeten Funktionsmodul 55. Der Übersichtlichkeit halber wird das System im Folgenden nur im Zusammenhang mit dem Basismodul 1 gemäß der ersten Ausführungsform beschrieben. Die Beschreibung gilt dann analog auch für das zweite Basismodul 18, das dritte Basismodul 22, das vierte Basismodul 33, das fünfte Basismodul 36 und das sechste Basismodul 41.

Die Unterseite 58 des Modulgehäuses 56 des Funktionsmoduls 55 liegt dabei an einem Teil der Oberseite 3 des Gehäuses 2 des Basismoduls 1 an. Das erste Modulanschlusselement 61 des Funktionsmoduls 55 greift dabei in das erste Anschlusselement 14 des Basismoduls 1 ein.

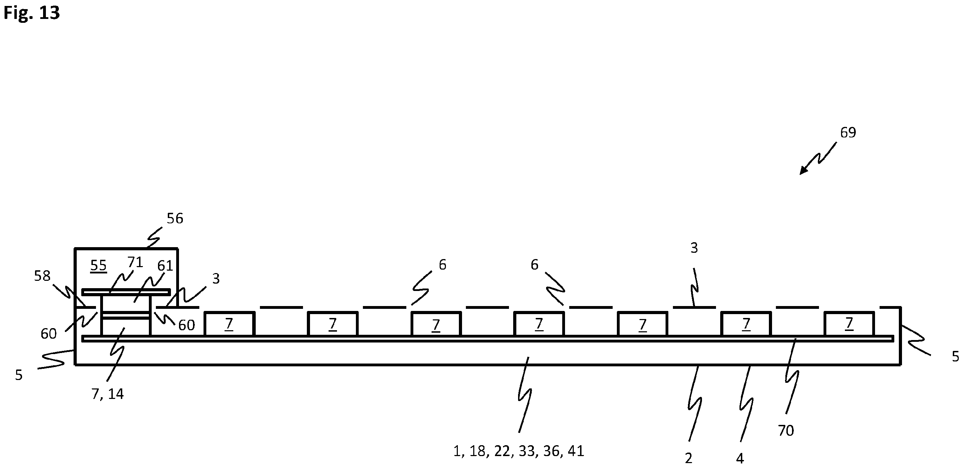

Fig. 13 zeigt schematisch das Schaltschranksystem 69 der Fig. 12 in einer Querschnittsansicht auf eine in Fig. 12 mittels gestrichelten Linien dargestellte Ebene XIII-XIII.

Die Anschlusselemente 7 des Basismoduls 1 können, wie in Fig. 13 beispielhaft dargestellt ist, auf einer im Gehäuse 2 angeordneten gedruckten Leiterplatte 70 angeordnet sein. Das Modulanschlusselement 61 des Funktionsmoduls 55 kann auf einer im Modulgehäuse 56 angeordneten gedruckten Modulleiterplatte 71 angeordnet sein. Das Modulanschlusselement 61 ragt durch die Öffnung 60 des Modulgehäuses 56 und durch eine Öffnung 6 des Basismoduls 1 und greift in das erste Anschlusselement 14 des Basismoduls 1 ein.

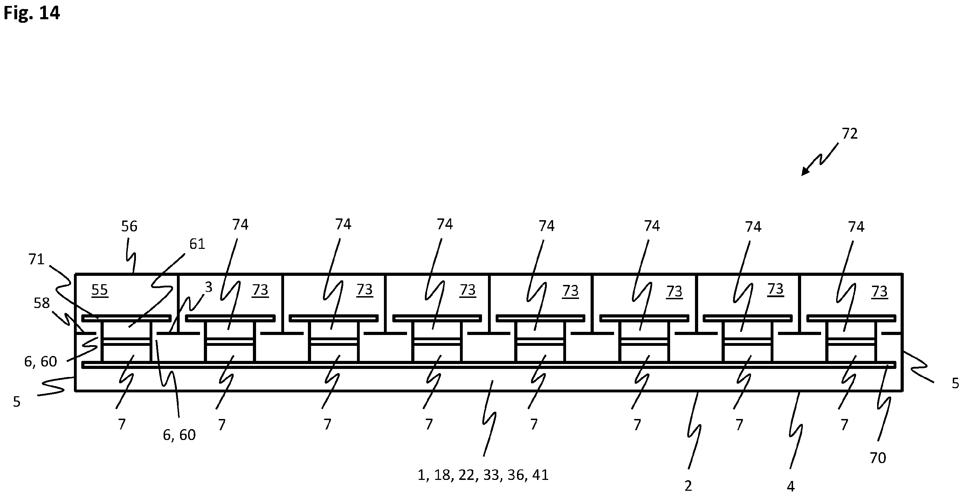

Fig. 14 zeigt schematisch ein weiteres Schaltschranksystem 72 in einer der Fig. 13 entsprechenden Querschnittsansicht. Wie beim Schaltschranksystem 69, weist das weitere Schaltschranksystem 72 beispielhaft das erste Basismodul 1 gemäß der ersten Ausführungsform auf. Die Beschreibung gilt analog auch für das zweite Basismodul 18, das dritte Basismodul 22, das vierte Basismodul 33, das fünfte Basismodul 36 und das sechste Basismodul 41.

Das weitere Schaltschranksystem 72 weist neben dem als Einspeisemodul ausgebildeten Funktionsmodul 55 zumindest ein weiteres Funktionsmodul 73 auf, das als Ausgabemodul ausgebildet ist. Beispielhaft weist das weitere Schaltschranksystem 72 der Fig. 14 sieben weitere Funktionsmodule 73 auf. Jedes der weiteren Funktionsmodule 73 weist ein weiteres Modulanschlusselement 74 auf. Jedes weitere Modulanschlusselement 74 ragt durch eine Öffnung 6 des Basismoduls 1. Jedes weitere Modulanschlusselement 73 der weiteren Funktionsmodule 73 greift in ein Anschlusselement 7 des Basismoduls 1 ein. Daten und Versorgungsspannungen, die über das als Einspeisemodul ausgebildete Funktionsmodul 55 in das Basismodul 1 eingespeist werden können, können vom Basismodul 1 in die weiteren Funktionsmodule 73 eingespeist werden. Die weiteren Funktionsmodule 73 können beispielsweise Versorgungsspannungen an Teilnehmer im Feld weiterleiten.

Das weitere Schaltschranksystem 72 bietet den Vorteil, dass im Fall eines Defekts oder eines Austauschs eines weiteren Funktionsmoduls 73 noch intakte weitere Funktionsmodule 73 über den Datenbus 10 angesprochen werden können. Ermöglicht wird dies durch die im ersten Basismodul 1 angeordneten Anschalteinheiten 9, die jeweils mit den Anschlusselementen 7 verbunden sind. Das weitere Funktionsmodul 73 kann aus diesem Grund im laufenden Betrieb eines das weitere Schaltschranksystem 72 umfassenden Automatisierungssystems ausgetauscht werden. Dabei muss das Automatisierungssystem nicht initialisiert werden, wenn ein ersetzendes weiteres Funktionsmodul 74 bereits konfiguriert ist. Bei einem Einsatz des weiteren Schaltschranksystems 72 bzw. des das weitere Schaltschranksystem 72 umfassenden Automatisierungssystems beispielsweise in einer Produktionsmaschine kann dies einen Produktionsausfall verhindern.

## Patentansprüche

1. Basismodul (1, 18, 22, 33, 36, 41) für ein Schaltschranksystem (69, 72) mit einer Mehrzahl von Anschalteinheiten (9) und Anschlusselementen (7) für eine Mehrzahl von Funktionsmodulen (55, 73),
wobei die Anschlusselemente (7) dazu ausgebildet sind, in Modulanschlusselemente (61) von Funktionsmodulen (55, 73) einzugreifen,
wobei jedes Anschlusselement (7) zumindest einen Datenanschluss (11, 47, 48) aufweist,
wobei jede Anschalteinheit (9) jeweils zumindest mit einem Datenanschluss(11, 47,48) eines Anschlusselements (7) verbunden ist,
wobei die Anschalteinheiten (9) durch einen Datenbus (10) miteinander verbunden sind,
wobei das Basismodul (1, 18, 22, 33, 36, 41) einen ersten Feldbusanschluss (12) aufweist,
wobei der Datenbus (10) zum Anbinden der Anschalteinheiten (9) an einen Feldbus mit dem ersten Feldbusanschluss (12) verbunden ist,
**dadurch gekennzeichnet, dass** zumindest ein Anschlusselement (7) zur Kommunikation mit einem Funktionsmodul (55, 73) einen als Serial Peripheral Interface (SPI)-Anschluss ausgebildeten weiteren Datenanschluss (46) aufweist.

2. Basismodul (1, 18, 22, 33, 36, 41) gemäß Anspruch 1,
wobei ein Datenanschluss (11) eines ersten Anschlusselements (14) den ersten Feldbusanschluss (12) bildet,
wobei der Datenanschluss (11) dazu ausgebildet ist, in einen ersten Moduldatenanschluss (64) eines ersten Modulanschlusselements (61) eines Funktionsmoduls (55) einzugreifen.

3. Basismodul (18) gemäß Anspruch 1 oder 2,
wobei ein Datenanschluss (11) eines zweiten Anschlusselements (20) einen zweiten Feldbusanschluss (21) bildet,
wobei der Datenbus (10) mit dem zweiten Feldbusanschluss (21) verbunden ist,
wobei der Datenanschluss (11) des zweiten Anschlusselements (20) dazu ausgebildet ist, in einen ersten Moduldatenanschluss eines zweiten Modulanschlusselements eines Funktionsmoduls (55) einzugreifen.

4. Basismodul (22, 33, 36, 41) gemäß einem der Ansprüche 1 bis 3,
wobei ein erster Spannungsanschluss (23) eines der Anschlusselemente (7) einen ersten Versorgungsanschluss (24) zum Einspeisen einer ersten Versorgungsspannung in das Basismodul (22, 33, 36, 41) bildet,
wobei zumindest eines der übrigen Anschlusselemente (7) einen weiteren ersten Spannungsanschluss (25) zum Weiterleiten der ersten Versorgungsspannung an ein Funktionsmodul (73) aufweist,
wobei der erste Versorgungsanschluss (24) mit dem weiteren ersten Spannungsanschluss (25) verbunden ist.

5. Basismodul (33, 36, 41) gemäß Anspruch 4,
mit einer an den Datenbus (10) angebunden Sicherungseinrichtung (34),
wobei die Sicherungseinrichtung (34) zumindest mit einer Sicherungsschaltung (35) verbunden ist,
wobei die Sicherungsschaltung (35) mit dem ersten Versorgungsanschluss (24) verbunden ist,
wobei die Sicherungsschaltung (35) zum abgesicherten Weiterleiten der ersten Versorgungsspannung an ein Funktionsmodul (73) mit dem weiteren ersten Spannungsanschluss (25) verbunden ist.

6. Basismodul (36, 41) gemäß einem Anspruch 4 oder 5,
wobei der erste Versorgungsanschluss (24) mit einem Wandler (37) verbunden ist,
wobei der Wandler (37) mit jeder Anschalteinheit (9) verbunden ist,
wobei der Wandler (37) dazu ausgebildet ist, den Anschalteinheiten (9) aus der ersten Versorgungsspannung eine Busspannung für einen Betrieb bereitzustellen.

7. Basismodul (36, 41) gemäß Anspruch 6,
wobei zumindest eines der Anschlusselemente (7) einen Busspannungsanschluss (39) zum Weiterleiten der Busspannung an ein Funktionsmodul (55, 73) aufweist,
wobei der Wandler (37) mit dem Busspannungsanschluss (39) verbunden ist.

8. Basismodul (41) gemäß einem der vorhergehenden Ansprüche,
wobei eine Überwachungseinheit (42) an den Datenbus (10) angebunden ist,
wobei die Überwachungseinheit (42) zumindest einen Sensoranschluss (43) aufweist.

9. Schaltschranksystem (69, 72)
mit einem Basismodul (1, 18, 22, 33, 36, 41) gemäß einem der Ansprüche 1 bis 8 und einem Funktionsmodul (55) mit einem ersten Modulanschlusselement (61), das dazu ausgebildet ist, in ein Anschlusselement (7) eines Basismoduls (1, 18, 22, 33, 36, 41) gemäß einem der vorhergehenden Ansprüche einzugreifen,
wobei das Funktionsmodul (55) einen ersten Feldbusmodul-anschluss (63) aufweist, wobei das erste Modulanschlusselement (61) einen ersten Moduldatenanschluss (64) aufweist,
wobei der erste Feldbusmodulanschluss (63) mit dem ersten Moduldatenanschluss (64) verbunden ist,
wobei der erste Moduldatenanschluss (64) dazu ausgebildet ist, in einen den ersten Feldbusanschluss (12) bildenden ersten Datenanschluss (11) eines ersten Anschlusselements (14) des Basismoduls (1, 18, 22, 33, 36, 41) einzugreifen,
wobei das erste Modulanschlusselement (61) des Funktionsmoduls (55) in ein erstes Anschlusselement (14) des Basismoduls (1, 18, 22, 33, 36, 41) eingreift.

10. Schaltschranksystem (69, 72) gemäß Anspruch 9,
wobei das Funktionsmodul (55) eine weitere Anschalteinheit (65 aufweist),
wobei die weitere Anschalteinheit (65) mit dem ersten Feldbusmodulanschluss (63) und mit dem ersten Moduldatenanschluss (64) verbunden ist,
wobei die weitere Anschalteinheit (65) mit einer elektronischen Schaltung (66) verbunden ist.

11. Schaltschranksystem (69, 72) gemäß Anspruch 9 oder 10,
wobei das Funktionsmodul (55) einen Modulversorgungsanschluss (67) zum Einspeisen einer Versorgungsspannung in das Funktionsmodul (55) aufweist,
wobei der Modulversorgungsanschluss (67) zum Weiterleiten der Versorgungsspannung an das Basismodul (1, 18, 22, 33, 36, 41) mit einem Spannungsanschluss (68) des ersten Modulanschlusselements (61) verbunden ist.

12. Schaltschranksystem (69, 72) gemäß einem der Ansprüche 9 bis 11,
wobei das Funktionsmodul (55) einen zweiten Feldbusmodulanschluss und einem zweiten Modulanschlusselement,
wobei das zweite Modulanschlusselement einen ersten Moduldatenanschluss aufweist,
wobei der zweite Feldbusmodulanschluss mit dem ersten Moduldatenanschluss des zweiten Modulanschlusselements verbunden ist,
wobei der erste Moduldatenanschluss des zweiten Modulanschlusselements dazu ausgebildet ist, in einen einen zweiten Feldbusanschluss (21) bildenden ersten Datenanschluss (11) eines zweiten Anschlusselements (20) des Basismoduls (18) einzugreifen.

13. Schaltschranksystem (72) gemäß einem der Ansprüche 9 bis 12,
mit zumindest einem weiteren Funktionsmodul (73),
wobei ein weiteres Modulanschlusselement (74) des weiteren Funktionsmoduls (73) in ein Anschlusselement (7) des Basismoduls (1, 18, 22, 33, 36, 41) eingreift.

## Claims

1. Basic module (1, 18, 22, 33, 36, 41) for a switchgear cabinet system (69, 72)
having a plurality of interface units (9) and connection elements (7) for a plurality of functional modules (55, 73),
wherein the connection elements (7) are designed to engage with module connection elements (61) of functional modules (55, 73),
wherein each connection element (7) has at least one data connection (11, 47, 48),
wherein each interface unit (9) is connected to at least one respective data connection (11, 47, 48) of a connection element (7),
wherein the interface units (9) are connected to each other by way of a data bus (10),
wherein the basic module (1, 18, 22, 33, 36, 41) has a first field bus connection (12),
wherein the data bus (10) is connected to the first field bus connection (12) in order to connect the interface units (9) to a field bus,
**characterized in that** at least one connection element (7) has a further data connection (46) in the form of a serial peripheral interface (SPI) connection for the purpose of communication with a functional module (55, 73).

2. Basic module (1, 18, 22, 33, 36, 41) according to Claim 1,
wherein a data connection (11) of a first connection element (14) forms the first field bus connection (12), wherein the data connection (11) is designed to engage with a first module data connection (64) of a first module connection element (61) of a functional module (55).

3. Basic module (18) according to Claim 1 or 2,
wherein a data connection (11) of a second connection element (20) forms a second field bus connection (21), wherein the data bus (10) is connected to the second field bus connection (21),
wherein the data connection (11) of the second connection element (20) is designed to engage with a first module data connection of a second module connection element of a functional module (55).

4. Basic module (22, 33, 36, 41) according to one of Claims 1 to 3,
wherein a first voltage connection (23) of one of the connection elements (7) forms a first supply connection (24) for supplying the basic module (22, 33, 36, 41) with a first supply voltage,
wherein at least one of the remaining connection elements (7) has a further first voltage connection (25) for forwarding the first supply voltage to a functional module (73),
wherein the first supply connection (24) is connected to the further first voltage connection (25).

5. Basic module (33, 36, 41) according to Claim 4,
having a fuse device (34) connected to the data bus (10), wherein the fuse device (34) is connected to at least one fuse circuit (35),
wherein the fuse circuit (35) is connected to the first supply connection (24),
wherein the fuse circuit (35) is connected to the further first voltage connection (25) in order to forward the first supply voltage to a functional module (73) in a fuse-protected manner.

6. Basic module (36, 41) according to either of Claims 4 and 5,
wherein the first supply connection (24) is connected to a converter (37),
wherein the converter (37) is connected to each interface unit (9),
wherein the converter (37) is designed to provide the interface units (9) with a bus voltage from the first supply voltage for operation.

7. Basic module (36, 41) according to Claim 6,
wherein at least one of the connection elements (7) has a bus voltage connection (39) for forwarding the bus voltage to a functional module (55, 73),
wherein the converter (37) is connected to the bus voltage connection (39).

8. Basic module (41) according to any one of the preceding claims,
wherein a monitoring unit (42) is connected to the data bus (10),
wherein the monitoring unit (42) has at least one sensor connection (43).

9. Switchgear cabinet system (69, 72)
having a basic module (1, 18, 22, 33, 36, 41) according to any one of Claims 1 to 8 and a functional module (55) having a first module connection element (61) which is designed to engage with a connection element (7) of a basic module (1, 18, 22, 33, 36, 41) according to any one of the preceding claims,
wherein the functional module (55) has a first field bus module connection (63),
wherein the first module connection element (61) has a first module data connection (64),
wherein the first field bus module connection (63) is connected to the first module data connection (64), wherein the first module data connection (64) is designed to engage with a first data connection (11), forming the first field bus connection (12), of a first connection element (14) of the basic module (1, 18, 22, 33, 36, 41), wherein the first module connection element (61) of the functional module (55) engages with a first connection element (14) of the basic module (1, 18, 22, 33, 36, 41).

10. Switchgear cabinet system (69, 72) according to Claim 9,
wherein the functional module (55) has a further interface unit (65),
wherein the further interface unit (65) is connected to the first field bus module connection (63) and to the first module data connection (64),
wherein the further interface unit (65) is connected to an electronic circuit (66).

11. Switchgear cabinet system (69, 72) according to Claim 9 or 10,
wherein the functional module (55) has a module supply connection (67) for supplying the functional module (55) with a supply voltage,
wherein the module supply connection (67) is connected to a voltage connection (68) of the first module connection element (61) in order to forward the supply voltage to the basic module (1, 18, 22, 33, 36, 41).

12. Switchgear cabinet system (69, 72) according to any one of Claims 9 to 11,
wherein the functional module (55) a second field bus module connection and a second module connection element, wherein the second module connection element has a first module data connection,
wherein the second field bus module connection is connected to the first module data connection of the second module connection element,
wherein the first module data connection of the second module connection element is designed to engage with a first data connection (11), forming a second field bus connection (21), of a second connection element (20) of the basic module (18).

13. Switchgear cabinet system (72) according to any one of Claims 9 to 12,
having at least one further functional module (73),
wherein a further module connection element (74) of the further functional module (73) engages with a connection element (7) of the basic module (1, 18, 22, 33, 36, 41).

## Revendications

1. Module de base (1, 18, 22, 33, 36, 41) pour un système d'armoire électrique (69, 72),
comprenant une pluralité d'unités de connexion (9) et d'éléments de raccordement (7) pour une pluralité de modules fonctionnels (55, 73),
les éléments de raccordement (7) étant configurés pour venir en prise dans des éléments de raccordement de module (61) des modules fonctionnels (55, 73),
chaque élément de raccordement (7) possédant au moins un port de données (11, 47, 48),
chaque unité de connexion (9) étant respectivement reliée à au moins un port de données (11, 47, 48) d'un élément de raccordement (7),
les unités de connexion (9) étant reliées les unes aux autres par un bus de données (10),
le module de base (1, 18, 22, 33, 36, 41) possédant un premier port de bus de terrain (12),
le bus de données (10) étant relié au premier port de bus de terrain (12) afin de rattacher les unités de connexion (9) à un bus de terrain,
**caractérisé en ce qu'**au moins un élément de raccordement (7), pour la communication avec un module fonctionnel (55, 73), possède un port de données supplémentaire (46) réalisé sous la forme d'un port SPI (Serial Peripheral Interface - Interface périphérique série).

2. Module de base (1, 18, 22, 33, 36, 41) selon la revendication 1,
un port de données (11) formant un premier élément de raccordement (14) du premier port de bus de terrain (12), le port de données (11) étant configuré pour venir en prise dans un premier port de données de module (64) d'un premier élément de raccordement de module (61) d'un module fonctionnel (55).

3. Module de base (18) selon la revendication 1 ou 2, un port de données (11) d'un deuxième élément de raccordement (20) formant un deuxième port de bus de terrain (21),
le bus de données (10) étant relié au deuxième port de bus de terrain (21),
le port de données (11) du deuxième élément de raccordement (20) étant configuré pour venir en prise dans un premier port de données de module d'un deuxième élément de raccordement de module d'un module fonctionnel (55) .

4. Module de base (22, 33, 36, 41) selon l'une des revendications 1 à 3,
un premier port de tension (23) de l'un des éléments de raccordement (7) formant un premier port d'alimentation (24) servant à l'injection d'une première tension d'alimentation dans le module de base (22, 33, 36, 41), au moins l'un des éléments de raccordement (7) restants possédant un premier port de tension supplémentaire (25) destiné à la retransmission de la première tension d'alimentation à un module fonctionnel (73),
le premier port d'alimentation (24) étant relié au premier port de tension supplémentaire (25).

5. Module de base (33, 36, 41) selon la revendication 4, comprenant un dispositif de sécurité (34) rattaché au bus de données (10),
le dispositif de sécurité (34) étant relié à au moins un circuit de sécurité (35),
le circuit de sécurité (35) étant relié au premier port d'alimentation (24),
le circuit de sécurité (35) étant relié au premier port de tension supplémentaire (25) en vue de la retransmission sécurisée de la première tension d'alimentation à un module fonctionnel (73).

6. Module de base (36, 41) selon la revendication 4 ou 5,
le premier port d'alimentation (24) étant relié à un convertisseur (37),
le convertisseur (37) étant relié à chaque unité de connexion (9),
le convertisseur (37) étant configuré pour fournir aux unités de connexion (9), à partir de la première tension d'alimentation, une tension de bus pour un fonctionnement.

7. Module de base (36, 41) selon la revendication 6, au moins l'un des éléments de raccordement (7) possédant un port de tension de bus (39) destiné à la retransmission de la tension de bus à un module fonctionnel (55, 73), le convertisseur (37) étant relié au port de tension de bus (39).

8. Module de base (41) selon l'une des revendications précédentes,
une unité de surveillance (42) étant rattachée au bus de données (10),
l'unité de surveillance (42) possédant au moins un port de capteur (43).

9. Système d'armoire électrique (69, 72),
comprenant un module de base (1, 18, 22, 33, 36, 41) selon l'une des revendications 1 à 8 et un module fonctionnel (55) pourvu d'un premier élément de raccordement de module (61), lequel est configuré pour venir en prise dans un élément de raccordement (7) d'un module de base (1, 18, 22, 33, 36, 41) selon l'une des revendications précédentes,
le module fonctionnel (55) possédant un premier port de module de bus de terrain (63),
le premier élément de raccordement de module (61) possédant un premier port de données de module (64),
le premier port de module de bus de terrain (63) étant relié au premier port de données de module (64),
le premier port de données de module (64) étant configuré pour venir en prise dans un premier port de données (11), formant le premier port de bus de terrain (12), d'un premier élément de raccordement (14) du module de base (1, 18, 22, 33, 36, 41),
le premier élément de raccordement de module (61) du module fonctionnel (55) venant en prise dans un premier élément de raccordement (14) du module de base (1, 18, 22, 33, 36, 41).

10. Système d'armoire électrique (69, 72) selon la revendication 9,
le module fonctionnel (55) possédant une unité de connexion supplémentaire (65),
l'unité de connexion supplémentaire (65) étant reliée au premier port de module de bus de terrain (63) et au premier port de données de module (64),
l'unité de connexion supplémentaire (65) étant reliée à un circuit électronique (66).

11. Système d'armoire électrique (69, 72) selon la revendication 9 ou 10,
le module fonctionnel (55) possédant un port d'alimentation de module (67) servant à l'injection d'une tension d'alimentation dans le module fonctionnel (55), le port d'alimentation de module (67) étant relié à un port de tension (68) du premier élément de raccordement de module (61) en vue de la retransmission de la tension d'alimentation au module de base (1, 18, 22, 33, 36, 41).

12. Système d'armoire électrique (69, 72) selon l'une des revendications 9 à 11,
le module fonctionnel (55) un deuxième port de module de bus de terrain et un deuxième élément de raccordement de module,
le deuxième élément de raccordement de module possédant un premier port de données de module,
le deuxième port de module de bus de terrain étant relié au premier port de données de module du deuxième élément de raccordement de module,
le premier port de données de module du deuxième élément de raccordement de module étant configuré pour venir en prise dans un premier port de données (11), formant un deuxième port de bus de terrain (21), d'un deuxième élément de raccordement (20) du module de base (18).

13. Système d'armoire électrique (72) selon l'une des revendications 9 à 12,
comprenant au moins un module fonctionnel supplémentaire (73),
un élément de raccordement de module supplémentaire (74) du module fonctionnel supplémentaire (73) venant en prise dans un élément de raccordement (7) du module de base (1, 18, 22, 33, 36, 41).
